# EUROPÄISCHE PATENTSCHRIFT

(11) **EP 1 770 836 B1**
(45) Veröffentlichungstag und Bekanntmachung des Hinweises auf die Patenterteilung: **22.04.2015**
(21) Anmeldenummer: 06019936.1
(22) Anmeldetag: 22.09.2006
(51) Int. Cl.: H01S 5/40, H01S 5/02, H01S 5/024, H01S 3/0941, H01S 5/022, H01S 5/04, H01S 5/14, H01S 5/183, H01S 5/22

(54) **Laserdiodenvorrichtung, Laseranordnung mit mindestens einer Laserdiodevorrichtung und optisch gepumpter Laser**
Laserdiode device, package with at least one laserdiode device and optically pumped laser
Dispositif à diode laser, assemblage avec au moins un dispositif à diode laser, et laser pompé optiquement

(30) Priorität: 29.09.2005 DE 102005046785
(43) Veröffentlichungstag der Anmeldung: 04.04.2007
(73) Patentinhaber: OSRAM Opto Semiconductors GmbH, 93055 Regensburg (DE)
(72) Erfinder: Brick, Peter, 93049 Regensburg (DE); König, Harald, 93170 Bernhardswald (DE); Moosburger, Jürgen, 93055 Regensburg (DE)
(74) Vertreter: Epping - Hermann - Fischer

(56) Entgegenhaltungen:
- EP-A2- 1 182 757
- JP-A- 2002 335 046
- JP-A- 2003 031 905
- JP-A- 2003 069 152
- JP-A- 2005 216 925
- US-A- 4 069 463
- US-A- 4 751 711
- US-A1- 2003 174 753
- US-A1- 2004 052 280

## Beschreibung

Die vorliegende Erfindung betrifft eine Laserdiodenvorrichtung mit einer Mehrzahl von zur Strahlungserzeugung geeigneten aktiven Bereichen und eine Laseranordnung mit einer derartigen Laserdiodenvorrichtung. Ferner betrifft die Erfindung einen optisch gepumpten Laser. Die Peak-Wellenlänge der in einem einzelnen aktiven Bereich eines Laserdiodenchips erzeugten Strahlung weist häufig einen maßgeblichen Temperaturgang auf, d. h. sie ändert sich mit der Betriebstemperatur des aktiven Bereichs. Bei Laserdioden auf GaAs-Basis ändert sich die Peak-Wellenlänge typischerweise um ungefähr 0,3 nm/K. Die Betriebstemperatur wird in der Regel maßgeblich von der bei der Strahlungserzeugung anfallenden Verlustwärme bestimmt, wobei die Verlustwärmemenge bei elektrisch gepumpten Lasern von der Umwandlungseffizienz von elektrischer Leistung in Strahlungsleistung im aktiven Bereich der Laserdiode abhängt. Bei Laserdiodenanordnungen mit einer Mehrzahl von aktiven Bereichen können verschiedene aktive Bereiche verschiedene Betriebstemperaturen aufweisen. Dies kann zu einer Erhöhung von Unterschieden in den Peak-Wellenlängen der in den jeweiligen aktiven Bereichen erzeugten Strahlung führen oder für das Entstehen derartiger Unterschiede ursächlich sein.

US 2003 0174753 A1 offenbart eine Anordnung mit einer Mehrzahl von diskreten Laserdiodenchips auf einem Träger, wobei der Abstand der Chips so gewählt ist, dass sich eine homogene Temperaturverteilung über die Chips ergibt.

Eine Aufgabe der vorliegenden Erfindung ist es, eine Laserdiodenvorrichtung mit einer Mehrzahl aktiver Bereiche bzw. eine Laseranordnung mit einer derartigen Laserdiodenvorrichtung anzugeben, wobei die Laserdiodenvorrichtung bzw. die Laseranordnung vereinfacht mit verringerter Schwankung zwischen den Betriebstemperaturen verschiedener aktiver Bereiche betreibbar ist. Weiterhin soll ein optisch gepumpter Laser angegeben werden, der vereinfacht effizient pumpbar ist.

Diese Aufgabe wird erfindungsgemäß durch eine Laserdiodenvorrichtung mit den Merkmalen des Anspruchs 1, eine Laseranordnung mit den Merkmalen des Anspruchs 20 bzw. einen Laser nach Anspruch 25 gelöst. Vorteilhafte Weiterbildungen und Ausgestaltungen der Erfindung sind Gegenstand der abhängigen Ansprüche.

Eine erfindungsgemäße Laserdiodenvorrichtung umfasst eine Mehrzahl von lateral nebeneinander angeordneten, zur Strahlungserzeugung geeigneten aktiven Bereichen, wobei die aktiven Bereiche in voneinander durch einen Freiraum beabstandeten Halbleiterkörpern ausgebildet sind, wobei jeder Halbleiterkörper eine kantenemittierende Laserstruktur ist. Die aktiven Bereiche sind auf einem gemeinsamen Substrat angeordnet, das aus dem Aufwachssubstrat für die aktiven Bereiche gebildet ist. Ferner emittieren alle aktiven Bereiche im Betrieb Laserstrahlung. Die Laserdiodenvorrichtung weist mindestens zwei die Laserdiodenvorrichtung lateral begrenzende Seitenfläche auf. Die aktiven Bereiche sind außerdem achsensymmetrisch zu einer Symmetrieachse der Laserdiodenvorrichtung angeordnet, wobei die Symmetrieachse senkrecht zur einer lateralen Haupterstreckungsrichtung der Laserdiodenvorrichtung und parallel zu derjenigen Oberfläche des Substrats, auf der die aktiven Bereiche angeordnet sind, verläuft. Ferner variiert eine Querabmessung der aktiven Bereiche in lateraler Richtung, wobei die Querabmessung der aktiven Bereiche mit wachsendem Abstand von der nächstliegenden Seitenfläche in Richtung der Symmetrieachse abnimmt, so dass die Querabmessung eines aktiven Bereichs im Bereich der nächstliegenden Seitenfläche größer ist als die Querabmessung eines weiteren aktiven Bereichs, der dem ersteren aktiven Bereich benachbart ist und weiter von der nächstliegenden Seitenfläche beabstandet ist als der erstere aktive Bereich. Auch weist die Laserdiodenvorrichtung im Betrieb eine Betriebstemperaturverteilung über verschiedene aktive Bereiche entlang der Haupterstreckungsrichtung der Laserdiodenvorrichtung auf, die verglichen mit einer weiteren Laserdiodenvorrichtung mit äquidistant angeordneten aktiven Bereichen jeweils gleicher Querabmessung homogener ist.

Die aktiven Bereiche sind zur Strahlungserzeugung im Betrieb der Laserdiodenvorrichtung ausgebildet.

Erfindungsgemäß weist die Laserdiodenvorrichtung eine laterale Haupterstreckungsrichtung auf. Die aktiven Bereiche sind besonders bevorzugt in der Haupterstreckungsrichtung nebeneinander aufgereiht angeordnet.

Zwei aktive Bereiche, zwischen denen ein weiterer aktiver Bereich angeordnet ist, sind im Zweifel nicht als benachbarte aktive Bereiche im obigen Sinne anzusehen.

Durch Variation der Querabmessungen der aktiven Bereiche kann die strahlungserzeugende aktive Fläche des jeweiligen aktiven Bereichs variiert werden. Hierüber kann die im jeweiligen aktiven Bereich anfallende Verlustwärmemenge gezielt beeinflusst werden. Je größer die strahlungserzeugende Fläche ist, desto größer ist in der Regel die im jeweiligen aktiven Bereich erzeugte Verlustwärmemenge und dementsprechend auch die Betriebstemperatur des jeweiligen aktiven Bereichs. Über örtliche Variation der Querabmessung der aktiven Bereiche und insbesondere über Variation der aktiven Fläche der aktiven Bereiche kann demnach die Betriebstemperaturverteilung über die aktiven Bereiche der Laserdiodenvorrichtung gezielt beeinflusst werden.

Entsprechendes gilt für die Variation des Abstands benachbarter aktiver Bereiche. Die Betriebstemperaturen zweier benachbarter aktiver Bereiche erhöhen sich in der Regel mit Verringerung des Abstands zwischen diesen aktiven Bereichen auf Grund der dann örtlich konzentrierteren Verlustwärmeerzeugung.

Über geeignete Variationen des Abstands benachbarter aktiver Bereiche und/oder der Querabmessung der aktiven Bereiche der Laserdiodenvorrichtung kann eine vorgegebene Verteilung der Betriebstemperatur der verschiedenen aktiven Bereiche der Laserdiodenvorrichtung in lateraler Richtung vereinfacht erreicht werden. Bevorzugt wird die Betriebstemperaturverteilung über entsprechende Anordnung und/oder Ausbildung der aktiven Bereiche derart geformt, dass sich eine vorgegebene Betriebstemperaturverteilung einstellt.

Erfindungsgemäß sind die aktiven Bereiche derart angeordnet und/oder ausgebildet, dass sich im Betrieb der Laserdiodenvorrichtung eine Betriebstemperaturverteilung über verschiedene aktive Bereiche entlang einer lateralen Haupterstreckungsrichtung der Laserdiodenvorrichtung einstellt, die verglichen mit einer weiteren Laserdiodenvorrichtung, die z.B. äquidistant angeordnete aktive Bereiche jeweils gleicher Querabmessung aufweist, homogener ist. Auf diese Weise kann eine betriebstemperaturstabilisierte Laserdiodenvorrichtung ausgebildet werden.

Insbesondere können die aktiven Bereiche derart angeordnet und/oder ausgebildet werden, dass die Betriebstemperatur der aktiven Bereiche an entsprechenden, gleich gewählten Orten der jeweiligen aktiven Bereiche gleich ist.

Hierzu kann beispielsweise zunächst eine Referenz-Laserdiodenvorrichtung gefertigt werden, die äquidistant angeordnete aktive Bereiche gleicher Querabmessungen aufweist. Nachfolgend kann die Betriebstemperaturverteilung der Referenz-Laserdiodenvorrichtung gemessen werden. In Gebieten der Referenz-Laserdiodenvorrichtung, in denen die aktiven Bereiche eine vergleichsweise niedrige Betriebstemperatur aufweisen, wird die nachfolgend herzustellende betriebstemperaturstabilisierte Laserdiodenvorrichtung mit aktiven Bereichen, die gegenüber denen der Referenz-Laserdiodenvorrichtung erhöhte Querabmessung und eventuell verringerten Abstand aufweisen, ausgebildet. Gegenüber den aktiven Bereichen niedriger Betriebstemperatur der Referenz-Laserdiodenvorrichtung wird in der betriebstemperaturstabilisierten Laserdiodenvorrichtung in diesem Gebiet der Laserdiodenvorrichtung gezielt eine erhöhte Verlustwärmemenge erzeugt. Hieraus resultiert dann in den jeweiligen aktiven Bereichen der betriebstemperaturstabilisierten Laserdiodenvorrichtung eine dementsprechend erhöhte Betriebstemperatur.

In der Folge können die Peak-Wellenlängen der von den aktiven Bereichen der Laserdiodenvorrichtung erzeugten Laserstrahlung stabilisiert werden. Besonders vorteilhaft ist dies bei aktiven Bereichen, die gleichartig, insbesondere zur Erzeugung von Strahlung gleicher Peak-Wellenlängen bei gleicher Betriebstemperatur, ausgebildet sind. Das Emissionsspektrum der Laserdiodenvorrichtung kann so gegenüber einem Emissionsspektrum einer Laserdiodenvorrichtung, die eine inhomogene Betriebstemperaturverteilung über verschiedene aktive Bereiche aufweist, aufgrund der Stabilisierung der Peak-Wellenlängen geschmälert werden. Dies ist insbesondere bei Anwendungen von Vorteil, für die ein schmalbandiges Emissionsspektrum zweckmäßig ist.

Ein schmalbandiges Emissionsspektrum ist beispielsweise bei Pumpanwendungen, bei denen eine Laserdiodenvorrichtung zum optischen Pumpen einer weiteren Strahlungsquelle, etwa eines Lasers eingesetzt wird von Vorteil.

Ein derartig zu pumpender Laser kann als Festkörperlaser, z.B. als Festkörperscheibenlaser oder Festkörperstablaser, als Faserlaser, oder als Halbleiterlaser, z.B. als Halbleiterlaser mit externem Resonator und/oder als Halbleiterscheibenlaser, ausgeführt sein. Optisch zu pumpende Laser weisen in der Regel ein vergleichsweise schmalbandiges Absorptionsspektrum in dem zu pumpenden Medium des Lasers auf. Eine Verbreiterung der Emissionscharakteristik der Laserdiodenvorrichtung mindert somit die Pumpeffizienz der als Pumplaser eingesetzten Laserdiodenanordnung. Einer derartigen Verbreiterung des Emissionsspektrums kann durch erfindungsgemäße Ausbildung der Laserdiodenvorrichtung entgegengewirkt werden.

Prinzipiell könnte die Betriebstemperatürverteilung auch durch eine Erhöhung der Effizienz der aktiven Bereiche bei der Strahlungserzeugung mit entsprechend verringerter Verlustwärmeerzeugung homogenisiert werden. Dies ist jedoch gegenüber einer Variation der Querabmessung der aktiven Bereiche bzw. des Abstands benachbarter aktiver Bereiche vergleichsweise aufwändig bzw. kostenintensiv.

Erfindungsgemäß weist die Laserdiodenvorrichtung zwei, die Laserdiodenvorrichtung lateral begrenzende, S eitenflächen auf. Im Bereich der Seitenfläche ist die Betriebstemperatur der in diesem Bereich der Laserdiodenvorrichtung angeordneten aktiven Bereiche, z. B. aufgrund besserer Wärmeabfuhr oder verringerter Verlustwärmeerzeugung, oftmals geringer als in weiter von der Seitenfläche entfernten Bereichen.

Erfindungsgemäß ist daher die Querabmessung eines aktiven Bereichs größer als die Querabmessung eines weiteren aktiven Bereichs, wobei dieser aktive Bereich dem ersteren aktiven Bereich benachbart ist und weiter von der Seitenfläche beabstandet ist als der erstere aktive Bereich

Zusätzlich kann der Abstand zwischen den aktiven Bereichen eines Paares mit zwei benachbarten aktiven Bereichen bevorzugt kleiner als der Abstand zwischen den aktiven Bereichen eines weiteren Paares mit zwei benachbarten aktiven Bereichen, das einen größeren Abstand zur Seitenfläche aufweist als das erstere Paar, sein. Hierbei weist mindestens ein aktiver Bereich des weiteren Paares einen größeren Abstand zur Seitenfläche auf als jeder aktive Bereich des ersteren Paares. In einer Abwandlung können beide Paare einen gemeinsamen aktiven Bereich aufweisen. Im Bereich der Seitenfläche kann auf diese Weise vereinfacht eine erhöhte Verlustwärmemenge erzeugt werden, wodurch die Betriebstemperatur in den nahe an der Seitenfläche angeordneten aktiven Bereiche der Laserdiodenvorrichtung gezielt erhöht werden kann.

Erfindungsgemäß nimmt die, insbesondere jeweilige, Querabmessung der aktiven Bereiche mit wachsendem Abstand der aktiven Bereiche zur Seitenfläche, insbesondere schrittweise, ab.

Zusätzlich kann der, insbesondere jeweilige, Abstand zwischen benachbarten aktiven Bereichen mit wachsendem Abstand der aktiven Bereiche von der Seitenfläche bevorzugt, insbesondere schrittweise, zunehmen. Die in von der Seitenfläche vergleichsweise weit entfernten aktiven Bereichen anfallende Verlustwärme ist durch diese Anordnung, ebenso wie die Betriebstemperatur dieser aktiven Bereiche, vereinfacht verringerbar. Hierdurch kann eine homogene Betriebstemperaturverteilung über die aktiven Bereiche der Laserdiodenvorrichtung in lateraler Richtung vereinfacht erzielt werden.

Bevorzugt umfasst die Laserdiodenvorrichtung vier oder mehr, bevorzugt zehn oder mehr, aktive Bereiche. Schwankungen in der Betriebstemperaturverteilung zwischen einzelnen aktiven Bereiche treten bei einer derartigen Laserdiodenvorrichtung aufgrund der Vielzahl an aktiven Bereich vermehrt auf. Eine Homogenisierung der Betriebstemperaturverteilung macht sich daher in diesem Falle besonders stark bemerkbar.

Erfindungsgemäß sind die aktiven Bereiche der Laserdiodenvorrichtung auf einem gemeinsamen Substrat angeordnet. Die Laserdiodenvorrichtung ist hierdurch besonders kompakt ausbildbar, wobei das Substrat die aktiven Bereiche bevorzugt mechanisch stabilisiert. Da sich bei einer derart kompakten Ausbildung der Laserdiodenvorrichtung Inhomogenitäten in der Betriebstemperaturverteilung der aktiven Bereiche besonders stark bemerkbar machen, ist eine Homogenisierung der Betriebstemperatur in diesem Falle von besonderem Vorteil.

Die Seitenfläche, die die Laserdiodenvorrichtung in lateraler Richtung begrenzt, ist bevorzugt zumindest bereichsweise durch das Substrat gebildet.

Um einer lateralen Wärmestromaufweitung mit der einhergehenden Betriebstemperaturminderung in aktiven Bereichen, die vergleichsweise nahe am vom Substrat gebildeten Bereich der Seitenfläche angeordnet sind, vorzubeugen, weist der der Seitenfläche nächstliegende aktive Bereich, insbesondere der dem vom Substrat gebildeten Bereich der Seitenfläche nächstliegende aktive Bereich, bevorzugt von der Seitenfläche einen Abstand auf, der kleiner oder gleich ist als einer der Abstände zwischen zwei benachbarten aktiven Bereichen.

In einer weiteren bevorzugten Ausgestaltung ist der Abstand des der Seitenfläche nächstliegenden aktiven Bereichs von der Seitenfläche kleiner als der Abstand zwischen diesem aktiven Bereich und einem diesem aktiven Bereich benachbarten aktiven Bereich, der bevorzugt auf der der Seitenfläche abgewandten Seite des der Seitenfläche nächstliegenden aktiven Bereichs angeordnet ist.

Weiterhin ist der Abstand des vom Substrat gebildeten Bereichs der Seitenfläche zum nächstliegenden aktiven Bereich bevorzugt kleiner als der kleinste der Abstände zwischen den aktiven Bereichen. Variiert der Abstand zwischen den aktiven Bereichen der Laserdiodenvorrichtung, können die Betriebstemperaturen der aktiven Bereiche auf diese Weise vereinfacht aneinander angeglichen werden. Gegebenenfalls kann ein aktiver Bereich an die Seitenfläche angrenzen und/oder bündig mit der Seitenfläche abschließen.

Erfindungsgemäß sind die aktiven Bereiche achsensymmetrisch zu einer Symmetrieachse der Laserdiodenvorrichtung angeordnet. Bevorzugt liegt die Symmetrieachse senkrecht zur lateralen Haupterstreckungsrichtung der Laserdiodenvorrichtung oder verläuft im Wesentlichen parallel zu einer Oberfläche des Substrats, auf der die aktiven Bereiche angeordnet sind. Eine derart symmetrische Anordnung erleichtert das Erzielen einer homogenen, symmetrischen Betriebstemperaturverteilung über die aktiven Bereiche der Laserdiodenvorrichtung.

In einer Abwandlung gehören zwei aktive Bereiche der Laserdiodenvorrichtung, insbesondere alle Bereiche der Laserdiodenvorrichtung jeweils, diskreten Laserdiodenchips an. Diese Chips sind dann zweckmäßigerweise auf dem Substrat befestigt. Bevorzugt ist das Substrat in diesem Falle durch eine Wärmesenke oder einen Submount gebildet. Der Submount ist bevorzugt als Wärmespreizer ausgebildet. Der Wärmespreizer ist besonders bevorzugt zwischen den Laserdiodenchips und einer zusätzlich vorgesehenen Wärmesenke angeordnet.

Der Submount ist vorzugsweise an einen thermischen Ausdehnungskoeffizienten der Laserdiodenchips, die vorzugsweise gleichartig ausgeführt sind, angepasst. Bei diskreten Laserdiodenchips kann die Stabilisierung der Betriebstemperatur auf besonders einfache Weise durch entsprechende Wahl der Abstände zwischen den einzelnen Chips bei der Montage der Chips auf dem Substrat erzielt werden. Im Falle diskreter Laserdiodenchips sind die aktiven Bereiche und insbesondere die einzelnen Laserdiodenchips durch einen Freiraum voneinander beabstandet. Die Laserdiodenchips sind bevorzugt gemäß kantenemittierenden Lasern ausgebildet.

Erfindungsgemäß gehören zwei aktive Bereiche einem gemeinsamen Laserdiodenchip, insbesondere einem Laserdiodenbarren, an. Das Substrat ist erfindungsgemäß durch das Aufwachssubstrat für die aktiven Bereiche des Laserdiodenchips gebildet oder aus dem Aufwachssubstrat ausgebildet. Bevorzugt ist die Laserdiodenvorrichtung als Laserdiodenchip ausgeführt.

Zwei aktive Bereiche des Laserdiodenchips, vorzugsweise alle aktiven Bereiche des Chips, können in einer Abwandlung durch diskret voneinander bestromte Bereiche einer durchgehenden aktiven Schicht, die bevorzugt Teil einer Halbleiterschichtenfolge des Laserdiodenchips ist, gebildet sein. Erfindungsgemäß sind zwei aktive Bereiche des Laserdiodenchips durch einen Freiraum voneinander beabstandet. Erfindungsgemäß sind die aktiven Bereiche in voneinander durch einen Freiraum beabstandeten Halbleiterkörpern ausgebildet sein.

In einer Abwandlung sind aktive Bereiche des Laserdiodenchips entweder als diskret voneinander bestromte Bereiche einer durchgehenden aktiven Schicht gebildet. Erfindungsgemäß sind die aktiven Bereich durch einen Freiraum voneinander beabstandet.

Im ersteren Fall kann eine Homogenisierung der Betriebstemperaturverteilung durch geeignete Ausbildung von elektrischen Kontakten, zum Beispiel Kontaktmetallisierungen, zur Bestromung des jeweiligen aktiven Bereichs erreicht werden. Die Kontakte können streifenartig und insbesondere nebeneinander auf der aktiven Schicht angeordnet sein. Weiterhin überdeckt der dem jeweiligen aktiven Bereich zugeordnete Kontakt diesen aktiven Bereich bevorzugt zumindest teilweise, besonders bevorzugt vollständig.

Die weiter oben und im Folgenden für die Abstände und/oder Querabmessungen von aktiven Bereichen beschriebenen Merkmale können demnach bei einem Laserdiodenchip, bei dem die entsprechenden aktiven Bereiche durch diskret voneinander bestromte Bereiche einer durchgehenden aktiven Schicht gebildet sind, für die entsprechende Ausbildung der Kontakte zur diskreten Bestromung der aktiven Schicht herangezogen werden. Dementsprechend kann durch die Ausgestaltung der Kontaktgeometrie - Variation der Breite und/oder der Abstände der Kontakte in lateraler Richtung - für die Bestromung diskreter aktiver Bereiche eine entsprechende Homogenisierung der Betriebstemperaturverteilung über die aktiven Bereiche erzielt werden.

Bei der Ausbildung des Laserdiodenchips mit über einen Freiraum voneinander beabstandeten aktiven Bereiche, z.B. in diskreten Halbleiterkörpern, kann eine Halbleiterschichtenfolge mit einer aktiven Schicht mittels einer geeigneten Maske derart strukturiert werden, dass die Querabmessung und die Abstände benachbarter aktiver Bereiche - z.B. diskreter Teilbereiche der vor der Strukturierung durchgehenden aktiven Schicht - über den Chip variiert.

Bei einem Laserdiodenbarren sind die aktiven Bereiche, insbesondere eine Halbleiterschichtstruktur, die den jeweiligen aktiven Bereich umfasst, für eine kantenemittierende Laserstruktur ausgebildet. Kantenemittierende Laserstrukturen emittieren Strahlung im Wesentlichen parallel zum aktiven Bereich. Weiterhin sind die aktiven Bereiche bevorzugt gleichartig ausgebildet, d. h. zur Erzeugung von Strahlung gleicher Peak-Wellenlänge bei gleichen Betriebstemperaturen. Erfindungsgemäß sind die aktiven Bereiche, insbesondere die aktive Schicht, epitaktisch auf dem Substrat gewachsen, das dann als Aufwachssubstrat dient.

Ein Laserdiodenbarren wird oftmals zur Erzeugung hoher Strahlungsleistung eingesetzt und dementsprechend mit hoher elektrischer Leistung betrieben. Wegen der hohen elektrischen Leistungsaufnahme können die Peak-Wellenlängen der in verschiedenen aktiven Bereichen erzeugten Strahlungen bei ungenügender Stabilisierung der Betriebstemperaturverteilung über die aktiven Bereiche bei einem Laserdiodenbarren erheblich voneinander abweichen. Dies kann im Rahmen der Erfindung vermieden werden.

Eine erfindungsgemäße Laseranordnung umfasst mindestens eine Laserdiodenvorrichtung, die eine die Laserdiodenvorrichtung lateral begrenzende Seitenfläche und eine Mehrzahl von lateral nebeneinander angeordneten, zur Strahlungserzeugung geeigneten aktiven Bereichen, wobei die Laserdiodenvorrichtung auf einem Träger angeordnet ist, der Abstand zwischen der Seitenfläche und einem den Träger seitens der Seitenfläche lateral begrenzenden Rand geringer ist als der Abstand zwischen dem der Seitenfläche nächstliegenden aktiven Bereich und der Seitenfläche und/oder der Abstand zwischen der Seitenfläche und dem Rand geringer ist als einer der Abstände zwischen zwei benachbarten aktiven Bereichen der Laserdiodenvorrichtung.

Die aktiven Bereiche sind erfindungsgemäß zur Strahlungserzeugung im Betrieb der Laserdiodenvorrichtung ausgebildet.

Der Träger der Laserdiodenvorrichtung ist also an die Abmessung der Laserdiodenvorrichtung angepasst. Bevorzugt ist der Träger derart an die Laserdiodenvorrichtung angepasst, dass die laterale Wärmestromaufweitung, insbesondere im Träger, vermindert ist. Auch hierüber kann, ebenso wie über die weiter oben beschriebenen Maßnahmen, die Betriebstemperaturverteilung über die aktiven Bereiche der Laserdiodenvorrichtung beeinflusst werden. Im Bereich der Seitenfläche der Vorrichtung von der Laserdiodenvorrichtung in den Träger abgeführte Verlustwärme unterliegt im Träger, aufgrund der vergleichsweise nahen Anordnung von Seitenfläche und Trägerrand relativ zueinander, nur einer relativ geringen lateralen randseitigen Wärmestromaufweitung. Die Betriebstemperatur der vergleichsweise nahe an der Seitenfläche liegenden aktiven Bereiche wird so - aufgrund der nur moderaten Wärmestromaufweitung im Träger - gegenüber der Betriebstemperatur weiter von der Seitenfläche entfernter aktiver Bereiche nicht maßgeblich verringert. Die Betriebstemperaturen der aktiven Bereiche können über eine derartige Anordnung der Laserdiodenvorrichtung relativ zum Träger vereinfacht aneinander angeglichen werden. Hierüber können, wie bereits weiter oben beschrieben, die Peak-Wellenlängen der in den verschiedenen aktiven Bereichen erzeugten Strahlungen stabilisiert werden.

Der Träger begrenzt die Laseranordnung bevorzugt zumindest teilweise in lateraler Richtung. Eine Anordnung der Seitenfläche möglichst nahe am Rand des Trägers hat sich als für eine Verringerung oder vollständige Vermeidung der randseitigen Wärmestromaufweitung besonders vorteilhaft erwiesen.

Bevorzugt ist der Abstand der Seitenfläche vom Rand geringer als der kleinste der Abstände zwischen den aktiven Bereichen der Laserdiodenvorrichtung. Besonders bevorzugt schließt die Seitenfläche, insbesondere auf ihrer dem Träger zugewandten Seite, bündig mit dem Träger ab. Eine Wärmestromaufweitung in lateraler Richtung im Träger kann so im Wesentlichen vollständig vermieden werden.

Ferner ist der Träger bevorzugt als Wärmesenke oder insbesondere als Submount ausgeführt. In den aktiven Bereichen anfallende Verlustwärme kann so zuverlässig über von den aktiven Bereichen weggeleitet werden.

Der Submount kann gegebenenfalls zwischen der Laserdiodenvorrichtung und einem weiteren Laseranordnungsträger, z.B. einer Wärmesenke, angeordnet sein. Vorzugsweise ist der Submount gegenüber der Wärmesenke besser an den thermischen Ausdehnungskoeffizienten eines Elements der Laserdiodenvorrichtung auf der dem Submount zugewandten Seite der Laserdiodenvorrichtung angepasst. Der Träger kann also insbesondere hinsichtlich des thermischen Ausdehnungskoeffizienten, beispielsweise mit einer Abweichung von 5 % oder weniger, an den thermischen Ausdehnungskoeffizienten der Laserdiodenvorrichtung angepasst sein. Die Gefahr thermisch verursachter Schädigungen der Laserdiodenvorrichtung kann so verringert werden.

Zur Anpassung des thermischen Ausdehnungskoeffizienten und hinsichtlich guter Wärmeleitfähigkeit ist ein Kupfer-Wolfram (CuWo) enthaltender Submount besonders geeignet. Über das Verhältnis Cu/Wo kann der thermische Ausdehnungskoeffizient eines derartigen Wärmespreizers verändert und an den thermischen Ausdehnungskoeffizienten der Laserdiodenvorrichtung, insbesondere an den des Substrats der Laserdiodenvorrichtung oder den eines seitens des Wärmespreizers angeordneten Halbleitermaterials angepasst werden. Eine besonders gute thermische Anpassung kann bei einem Laserdiodenchip auf GaAs-Basis, zum Beispiel mit einem GaAs-haltigen (Aufwachs)Substrat und/oder einem aktiven Bereich auf GaAs-Basis, erzielt werden.

Als Wärmesenke eignet sich besonders eine Cu-Wärmesenke.

In einer weiteren bevorzugten Ausgestaltung ist das Substrat auf der dem Träger abgewandten Seite der aktiven Bereiche angeordnet. Die Wärmeableitung von den aktiven Bereichen in den Träger kann so verbessert werden, da die Wärme nicht durch das Substrat geleitet werden muss. Das Substrat ist hierbei zweckmäßigerweise durch das Aufwachssubstrat gebildet. Die Gefahr einer Schädigung der Laserdiodenvorrichtung durch aufgrund eines Wärmestaus überhöhte Temperaturen kann so verringert werden. Allerdings werden aufgrund der verbesserten Wärmeableitung Unterschiede in den Betriebstemperaturen der aktiven Bereiche bei einer derartigen Anordnung des Substrats besonders stark erhöht.

Eine Betriebstemperaturstabilisierung mittels Variation der Querabmessungen und/oder der Abstände der aktiven Bereiche und/oder eine entsprechende Anpassung der Abmessungen der Laserdiodenvorrichtung an den Träger sind in diesem Falle von besonderem Vorteil.

In einer weiteren bevorzugten Ausgestaltung sind die Kontakte für die aktiven Bereiche zwischen dem Träger und der aktiven Schicht angeordnet.

Die Laserdiodenvorrichtung der Laseranordnung ist bevorzugt als erfindungsgemäße Laserdiodenvorrichtung ausgeführt. Die Betriebstemperaturverteilung kann so vereinfacht weitergehend beeinflusst werden. Weiter oben und im Folgenden im Zusammenhang mit der erfindungsgemäßen Laserdiodenvorrichtung beschriebene Merkmale können daher auch für die erfindungsgemäße Laseranordnung herangezogen werden und umgekehrt.

Die Laseranordnung und die Laserdiodenvorrichtung sind aufgrund der beeinflussbaren Betriebstemperaturverteilung vereinfacht mit in lateraler Richtung in den aktiven Bereichen gleichartig verlaufender Betriebstemperaturverteilung ausbildbar. Besonders stark bemerkbar macht sich dies bei gleichartig ausgebildeten aktiven Bereichen, die die Laserdiodenvorrichtung bevorzugt aufweist. Diese sollten nominell Strahlung der gleichen Peak-Wellenlänge emittieren, die jedoch aufgrund der Betriebstemperaturunterschiede variieren kann. Diese Schwankung kann bei der Erfindung verringert oder vollständig beseitigt werden. Eine derartig betriebstemperaturstabilisierte Laserdiodenvorrichtung bzw. eine entsprechende Laseranordnung ist demnach für eine Pumpanwendung, in der eine zu pumpende Strahlungsquelle über Absorption der von der Laserdiodenvorrichtung erzeugten Strahlung optisch gepumpt wird, besonders geeignet.

Ein erfindungsgemäßer optisch gepumpter Laser wird mittels einer erfindungsgemäßen Laserdiodenvorrichtung oder einer erfindungsgemäßen Laseranordnung gepumpt.

Aufgrund der stabilen Peak-Wellenlänge sind diese Laser als Pumplaser für ein effizientes Pumpen besonders geeignet.

Der zu pumpende Laser ist vorzugsweise als Festkörperlaser, insbesondere als Festkörperscheibenlaser oder Festkörperstablaser, als Faserlaser oder als Halbleiterlaser, insbesondere als Halbleiterscheibenlaser ausgeführt.

Besonders geeignet ist die Pumpstrahlungsquelle zum Pumpen eines Halbleiterlasers, insbesondere eines oberflächenemittierenden Halbleiterlasers, der zum Betrieb mit einem externen Resonator vorgesehen ist. Beispielsweise ist der Halbleiterlaser als VECSEL (Vertical External Cavity Surface Emitting Laser) und/oder Scheibenlaser ausgeführt.

Weitere Vorteile, Merkmale und bevorzugte Ausgestaltungen der Erfindung ergeben sich aus der Beschreibung der Ausführungsbeispiele in Verbindung mit den Figuren.
Figur 1 zeigt Abwandlungen einer Laseranordnung anhand einer schematischen Schnittansicht in Figur 1A und einer schematischen Aufsicht in Figur 1B, einer weiteren Laseranordnung anhand entsprechender Ansichten in den Figuren 1C und 1D, und einer weiteren Laseranordnung in Figur 1E sowie das quantitative Betriebstemperaturprofil einer Laseranordnung in Figur 1F,
Figur 2 zeigt eine Abwandlung einer Laseranordnung anhand Figur 2 zeigt eine Abwandlung einer Laseranordnung anhand einer schematischen Aufsicht in Figur 2A und einer schematischen Schnittansicht in Figur 2B,
Figur 3 zeigt zwei Abwandlungen eines Laserdiodenchips anhand schematischer Aufsichten in den Figuren 3A und 3B,
Figur 4 zeigt eine Abwandlung einer Laseranordnung anhand schematischer Schnittansichten in den Figuren 4A und 4B,
Figur 5 zeigt zwei Ausführungsbeispiele eines Laserdiodenchips anhand schematischer Aufsichten in den Figuren 5A und 5B,
Figur 6 zeigt eine schematische Ansicht eines Ausführungsbeispiels eines optisch gepumpten Halbleiterlasers, und
Figur 7 zeigt eine schematische Ansicht eines Ausführungsbeispiels eines optisch gepumpten Lasers.

Gleiche, gleichartige und gleich wirkende Elemente sind in den Figuren mit gleichen Bezugszeichen versehen.

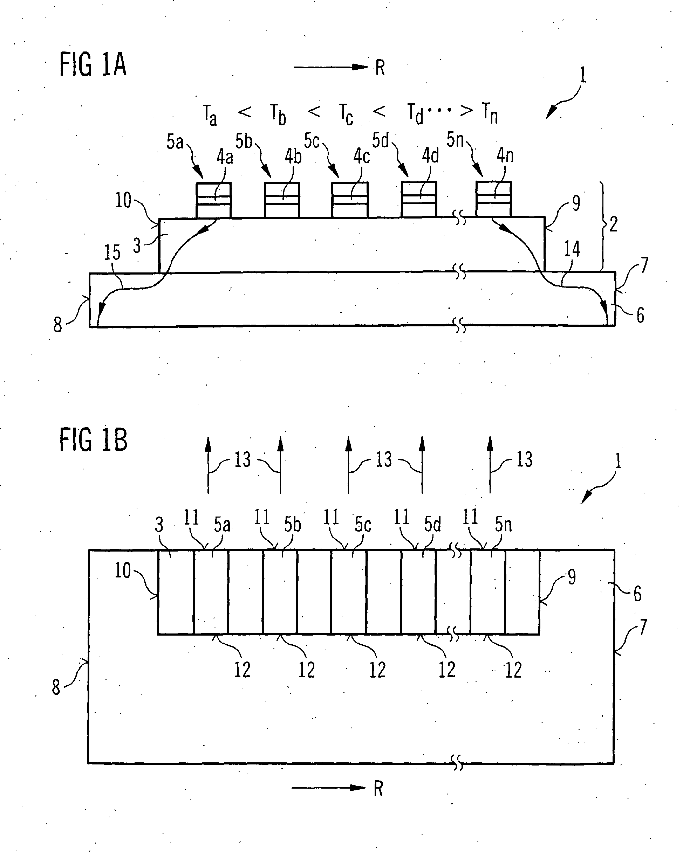

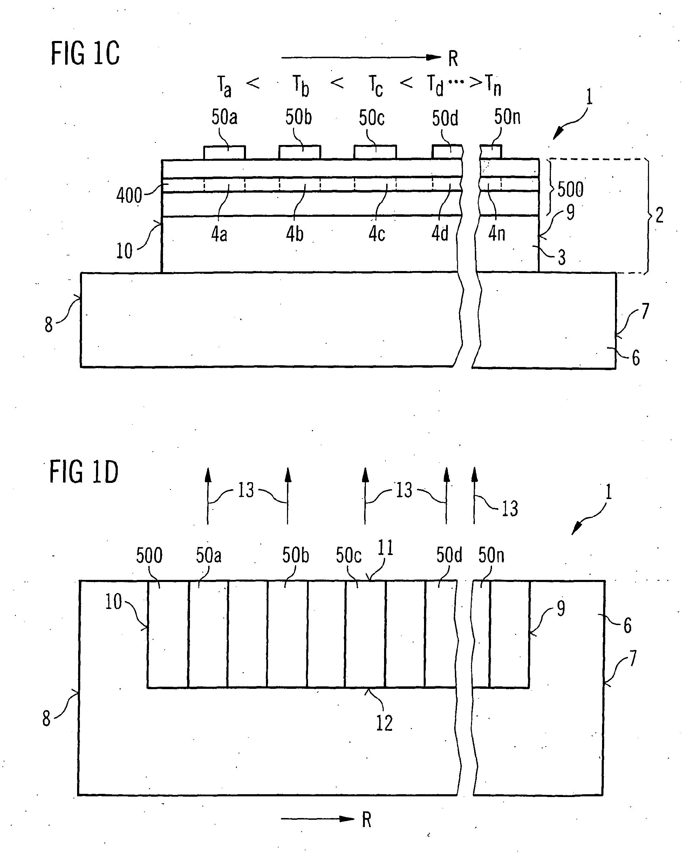

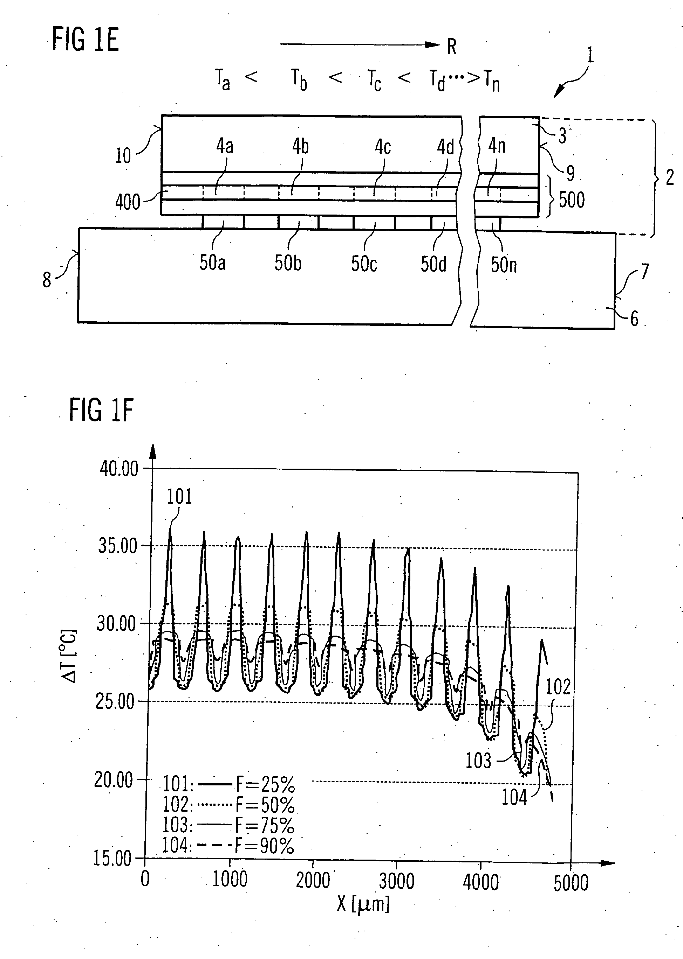

Figur 1 zeigt eine Abwandlung einer Laseranordnung 1 anhand einer schematischen Schnittansicht in Figur 1A und einer schematischen Aufsicht auf die Laseranordnung in Figur 1B.

Die Laseranordnung 1 umfasst einen Laserdiodenchip 2, der eine Mehrzahl von auf einem gemeinsamen Substrat 3 entlang einer lateralen Haupterstreckungsrichtung R des Laserdiodenchips nebeneinander angeordneten, zur Strahlungserzeugung geeigneten aktiven Bereichen 4a, 4b, 4c, 4d, ..., 4n umfasst. Vorzugsweise umfasst der Laserdiodenchip 2 zehn oder mehr aktive Bereiche, z.B. zwölf aktive Bereiche.

Gemäß der Darstellung in den Figuren 1A und 1B ist ein aktiver Bereich jeweils in einem Halbleiterkörper 5a, 5b, 5c, 5d, ..., 5n ausgebildet. Die Halbleiterkörper 5a ... 5n sind als diskrete, räumlich voneinander getrennt auf dem Substrat 3 angeordnete Halbleiterstrukturen ausgeführt. Die Halbleiterkörper 5a ... 5n sind insbesondere äquidistant auf dem Substrat 3 angeordnet und weisen gleiche Querabmessungen, d. h. gleiche Breiten, entlang der lateralen Haupterstreckungsrichtung auf. Eine Längsabmessung der Halbleiterkörper, d.h. deren Länge, senkrecht zur lateralen Haupterstreckungsrichtung ist bevorzugt größer als die Querabmessung und besonders bevorzugt konstant. Weiterhin weisen die aktiven Bereiche bevorzugt den gleichen Flächeninhalt, d.h. die gleiche aktive Fläche, auf.

Der Laserdiodenchip 2 der Laseranordnung 1 ist auf einem Träger 6 angeordnet, wobei das Substrat 3 bevorzugt zwischen den aktiven Bereichen 4a ... 4n und dem Träger angeordnet ist. Der Träger 6 ist in lateraler Richtung durch eine erste Randfläche 7 und eine zweite Randfläche 8 lateral begrenzt, wobei die zweite Randfläche 8 der ersten Randfläche 7 gegenüber liegt. Die Randflächen 7, 8 begrenzen zugleich auch die Laseranordnung 1 in lateraler Richtung. Der Laserdiodenchip 2 ist in lateraler Richtung durch eine erste Seitenfläche 9 und eine zweite Seitenfläche 10 begrenzt. Diese sind vom Substrat 3 gebildet. Die zweite Seitenfläche 10 liegt der ersten Seitenfläche 9 gegenüber. Weiterhin sind die Randflächen von den Seitenflächen beabstandet. Auch die aktiven Bereiche sind von den Seitenflächen 9 bzw. 10 beabstandet, sodass die Laseranordnung von den aktiven Bereichen ausgehend eine sich stufenartig lateral verbreiternde Struktur aufweist.

Die Halbleiterkörper 5a ... 5n sind gemäß kantenemittierenden Laserstrukturen ausgebildet. Ein Resonator für eine derartige Laserstruktur kann mittels einer ersten Reflektorfläche 11 und einer zweiten Reflektorfläche 12, die der jeweilige Halbleiterkörper 5a ... 5n aufweisen oder die am jeweiligen Halbleiterkörper ausgebildet sein kann, gebildet sein. Bevorzugt bildet eine Oberfläche des jeweiligen Halbleiterkörpers die jeweilige Reflektorfläche. Die erste Reflektorfläche 11 weist bevorzugt eine geringere Reflektivität auf als die zweite Reflektorfläche 12, sodass sich im Betrieb des Laserdiodenchips 2 ein Strahlungsfeld im Resonator des jeweiligen Halbleiterkörpers aufbauen, dort verstärkt werden und als Laserstrahlung 13 über die als Auskoppelfläche dienende Reflektorfläche 11 aus dem Resonator auskoppeln kann.

Bevorzugt sind die Halbleiterkörper 5a ... 5n monolithisch integriert ausgeführt. Die Halbleiterkörper können epitaktisch auf dem Substrat 3 gewachsen sein. Bevorzugt basieren die Halbleiterkörper auf GaAs. Ein GaAs-Substrat ist in diesem Fall als Substrat, insbesondere auch als Aufwachssubstrat für ein epitaktisches Wachsen der Halbleiterkörper, besonders geeignet.

Ferner sind die aktiven Bereichen bevorzugt gleichartig, insbesondere zur Emission von Laserstrahlung gleicher Peak-Wellenlänge bei gleicher Betriebstemperatur ausgebildet. Zur effizienten Strahlungserzeugung besonders geeignet sind aktive Bereiche, die eine Ein- oder Mehrfachquantenstruktur aufweisen. Die Bezeichnung Quantentopfstruktur beinhaltet keine Angabe über die Dimensionalität. Sie umfasst somit u.a. Quantentröge, Quantendrähte und Quantenpunkte und jede Kombination dieser Strukturen.

Laserdiodenchips auf (In,Al)GaAs-Basis eignen sich besonders zur Strahlungserzeugung im infraroten Spektralbereich.

Im Betrieb des Laserdiodenchips 2, etwa im quasikontinuierlichen Langpulsbetrieb (qcw: quasi-continuous wave) oder im kontinuierlichen Dauerstrichbetrieb (cw: continuous wave), wird in den aktiven Bereichen Strahlung erzeugt. Hierbei kann eine nicht unerhebliche Verlustwärmemenge anfallen. Bei Hochleistungslaserdiodenchips - z.B. mit einer Ausgangsleistung für einen Chip mit einem aktiven Bereich ≥ 1W, für einen Chip mit einer Mehrzahl aktiver Bereiche ≥ 10W - fällt dementsprechend eine besonders hohe Verlustwärmemenge an. Um die Gefahr einer wärmebedingten Schädigung der aktiven Bereiche nicht maßgeblich zu erhöhen, ist der Träger 6 zur Wärmeableitung vom Laserdiodenchip bevorzugt als Wärmesenke ausgeführt. Hierzu enthält der Träger 6 z.B. ein Metall, beispielsweise Cu, oder eine Legierung, z.B. CuWo, mit vorteilhaft hoher Wärmeleitfähigkeit. Die Wärme kann von den aktiven Bereichen über das Substrat 3 in den Träger 6 abgeführt werden.

Die Laseranordnung 1 kann mit dem Träger 6 auf einem Anschlussträger (nicht dargestellt), z.B. einer Leiterplatte, angeordnet und dort elektrisch kontaktiert werden. Auf eine explizite Darstellung elektrischer Kontakte der Laseranordnung wurde aus Übersichtlichkeitsgründen verzichtet. Der Träger kann als Submount für den Laserdiodenchip dienen, der zwischen dem Laserdiodenchip und dem Anschlussträger und/oder einer zusätzlichen Wärmesenke angeordnet ist.

In den aktiven Bereichen, die den Seitenflächen 9 und 10 benachbart sind bzw. nahe an den jeweiligen Seitenflächen angeordnet sind, z.B. den aktiven Bereichen 4a und 4n, anfallende Verlustwärme kann im Substrat 3 in lateraler Richtung zur jeweiligen Seitenfläche des Substrats geleitet werden. Vom Substrat 3 in vertikaler Richtung in den Träger 6 gelangende Wärme kann im Träger lateral in Richtung der Randflächen 9 und 10 geleitet werden. Der Wärmestrom kann also im Substrat bzw. im Träger in lateraler Richtung aufgeweitet werden. Dies ist in Figur 1A durch die sich in lateraler Richtung aufweitenden Wärmestromlinien 14 und 15 schematisch dargestellt. In den Randbereichen des Laserdiodenchips, d.h. den Bereichen nahe der Seitenflächen, wird verglichen mit einem mittigen Zentralbereich des Laserdiodenchips 2 eine geringere Verlustwärmemenge erzeugt. Diese Wärme wird aufgrund der Wärmestromaufweitung und der seitens der Seitenfläche vergleichsweise großen, zur Wärmeableitung zur Verfügung stehenden Fläche vermehrt von den aktiven Bereichen abgeleitet.

In der Folge bildet sich in lateraler Richtung ein Gradient in der Betriebstemperatur der aktiven Bereiche aus. Die Betriebstemperaturen Tₐ, T_{b}, T_{c}, T_{d}, ... und Tₙ der aktiven Bereiche 4a, 4b, 4c, 4d, ..., bzw. 4n nehmen daher mit wachsendem Abstand von den Seitenflächen 9 und 10 in lateraler Richtung zu. Je weiter die aktiven Bereiche von den Seitenflächen 9 und 10 bzw. den Randflächen 7 und 8 entfernt sind, desto weniger beeinflusst die randseitige laterale Wärmestromaufweitung die Betriebstemperatur der jeweiligen aktiven Bereiche. Die Wärme kann in relativ weit von den Seitenflächen entfernten Gebieten des Laserdiodenchips vielmehr im wesentlichen ohne Verbreiterung des Wärmestroms und direkt in vertikaler Richtung von den aktiven Bereichen abgeführt werden.

Die Betriebstemperaturen der aktiven Bereiche werden bevorzugt an entsprechenden Orten des jeweiligen aktiven Bereichs entlang der lateralen Haupterstreckungsrichtung bestimmt. Beispielsweise wird die Betriebstemperatur eines aktiven Bereichs in der Mitte dieses aktiven Bereichs seitens der ersten Reflektorfläche 11 bestimmt.

Auch bei nebeneinander angeordneten Einzelchips, das heißt einer Mehrzahl von auf einem Chipträger montierten getrennt voneinander hergestellten Laserdiodenchips kann bei äquidistanter Anordnung der Chips ein Gradient in der Betriebstemperaturverteilung aufgrund der lateralen Wärmestromaufweitung im Chipträger auftreten (nicht explizit dargestellt). In diesem Falle entsprechen der Darstellung in Figur 1 die Halbleiterkörper einzelnen Laserdiodenchips, das Substrat 3 dem Chipträger, der z.B. als Wärmespreizer oder Submount ausgeführt ist, und der Träger 6 einer Wärmesenke oder einem Anschlussträger für die auf dem Chipträger montierten Chips. Für thermisch angepasste Ausdehnungskoeffizienten zu den einzelnen Laserdiodenchips ist ein CuWo-Submount und eine Cu-Wärmesenke besonders geeignet. Die einzelnen Laserdiodenchips sind vorzugsweise zur Erzeugung von Strahlung der gleichen Peak-Wellenlänge ausgebildet.

Die in den Figuren 1C und 1D schematisch dargestellte Laseranordnung 1 entspricht im Wesentlichen der in den Figuren 1A und 1B dargestellten Laseranordnung. Im Unterschied hierzu weist der Laserdiodenchip 2 eine Halbleiterschichtstruktur 500 mit einer durchgehenden aktiven Schicht 400 auf, die auf dem Substrat 3 angeordnet ist. Die Halbleiterschichtstruktur 500 schließt vorzugsweise bündig mit den Seitenflächen 9, 10 des Substrats 3 ab. Im Gegensatz zu den Figuren 1A und 1B sind die aktiven Bereiche 4a ... 4n des Laserdiodenchips 2 durch im Betrieb des Halbleiterchips diskret voneinander bestromte Bereiche der aktiven Schicht 400 gebildet. Die Reflektorflächen 11, 12 sind weiterhin durch eine durchgehende Fläche ausgebildet. Die aktiven Bereiche 4a ... 4n sind jeweils von einem elektrischen Kontakt, insbesondere einer Kontaktmetallisierung, überdeckt. Vorzugsweise ist jedem aktiven Bereich genau ein Kontakt zugeordnet.

Die diskreten Kontakte 50a ... 50n entsprechen in ihrer Formgebung und Anordnung jeweils den Halbleiterkörpern 5a ... 5n gemäß den Figuren 1A und 1B. Insbesondere sind die Kontakte 50a ... 50n äquidistant in lateraler Richtung auf der Halbleiterschichtstruktur 500 angeordnet. In der Folge sind die im Betrieb des Laserdiodenchips 2 strahlungserzeugenden aktiven Bereiche 4a ... 4n ebenso äquidistant angeordnet. Vorzugsweise sind die Kontakte als, insbesondere parallel zueinander verlaufende, Kontaktstreifen ausgebildet. Die Kontakte weisen weiterhin gleiche Breiten auf.

Dementsprechend kann die Betriebstemperaturverteilung in lateraler Richtung bei dem in den Figuren 1C und 1D gezeigten Laserdiodenchip 2 ebenso inhomogen wie die des Chips gemäß den Figuren 1A und 1B verlaufen. Aufgrund der durchgehenden Halbleiterschichtstruktur, die neben der aktiven Schicht 400 vorzugsweise eine Mehrzahl weiterer Halbleiterschichten enthält, kann der Wärmeabtransport von den aktiven Bereichen sogar noch weitergehend gehemmt sein. Die Schwankungen in der Betriebstemperatur können gegenüber den voneinander über einen Freiraum beabstandeten aktiven Bereichen sogar noch erhöht sein.

Der Laserdiodenchip 2 kann auf dem Träger 6 durch eine, vorzugsweise elektrisch und/oder thermisch leitende Verbindungsschicht (nicht dargestellt) befestigt und insbesondere elektrisch und/oder thermisch leitend mit dem Träger 6 verbunden sein. Die Verbindungsschicht ist vorzugsweise zwischen dem Laserdiodenchip und dem Träger 6 angeordnet. Die Verbindungsschicht kann als Lotschicht, insbesondere als In-Lotschicht, ausgeführt sein.

Um die aktiven Bereiche 4a ... 4n für eine verbesserte Wärmeableitung näher am Träger anzuordnen, können die aktiven Bereiche zwischen dem Träger 6 und dem Substrat 3 angeordnet sein. Insbesondere können die Kontakte 50a ... 50n zur diskreten Bestromung der aktiven Schicht zwischen der Halbleiterschichtstruktur 500 und dem Träger 6 angeordnet sein (Figur 1E). Über eine Anordnung des Substrats 3 auf der dem Träger abgewandten Seite der aktiven Bereiche kann die Wärmeableitung von den aktiven Bereichen verbessert werden. Die Gefahr einer aufgrund überhöhter Temperaturen verursachten Schädigung des Laserdiodenchips im Betrieb der Laseranordnung 1 wird so verringert. Da die thermische Anbindung an den Träger 6 bei einer derartigen Ausgestaltung verbessert ist, macht sich auch eine laterale Wärmestromaufweitung im Träger verstärkt bemerkbar. Hierdurch werden die Schwankungen in den Peak-Wellenlängen weitergehend verstärkt.

Die in den Figuren 1A bis 1E dargestellten Laserdiodenchips sind vorzugsweise als Laserdiodenbarren ausgebildet.

Figur 1F zeigt quantitativ das Betriebstemperaturprofil, d.h. die Änderung der Betriebstemperatur ΔT in °C entlang der Strecke x in µm entlang der lateralen Haupterstreckungsrichtung, von der Mitte des Laserdiodenchips ausgehend in Richtung der Seitenfläche 9 des Substrats 3 für eine Laseranordnung ähnlich den in den Figuren 1A, 1B bzw. 1C, 1D und 1E gezeigten Anordnungen für verschiedene Füllfaktoren F des Substrats mit aktiven Bereichen. Die Abnahme der Betriebstemperaturen in Richtung der Seitenfläche ist deutlich zu erkennen.

Da die Peak-Wellenlänge der im jeweiligen aktiven Bereich erzeugten Strahlung von dessen Betriebstemperatur abhängt, führt dieser Gradient der Betriebstemperatur zu verschiedenen Peak-Wellenlängen der in den jeweiligen aktiven Bereichen erzeugten Strahlung. Das Emissionsspektrum des Laserdiodenchips 2 wird also aufgrund der Temperaturabhängigkeit der Peak-Wellenlänge verbreitert. Dies kann für Anwendungen der Laseranordnung, etwa für das Pumpen eines Festkörperlasers, der in der Regel ein schmales Absorptionsspektrum aufweist, unerwünscht sein. Die Peak-Wellenlänge kann sich um 0,3 nm/K ändern, sodass sich Unterschiede in der Betriebstemperatur zwischen verschiedenen aktiven Bereichen von bis zu ungefähr 40 K, die sich in lateraler Richtung ergeben können, maßgeblich auf die Breite des Emissionsspektrums des Laserdiodenchips auswirken können.

Über geeignete Anordnung und/oder Ausbildung der aktiven Bereiche des Laserdiodenchips 2 und/oder geeignete Abstimmung des Laserdiodenchips und des Trägers aufeinander, kann dieser betriebstemperaturgradientenbedingten Peak-Wellenlängenverschiebung im Rahmen der Erfindung entgegengewirkt werden.

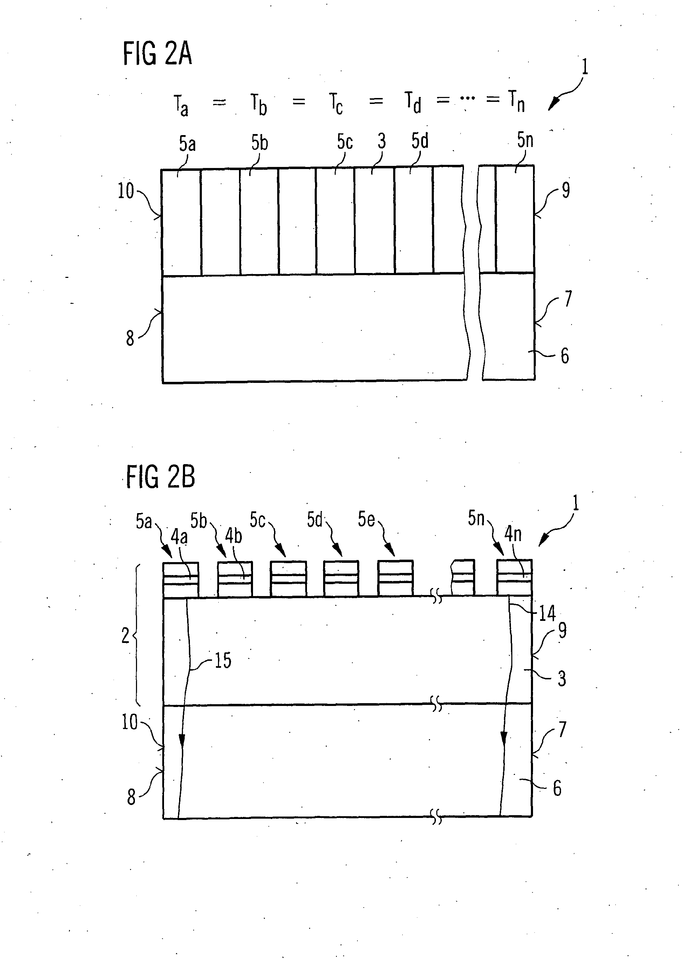

Figur 2 zeigt eine Abwandlungeiner Laseranordnung 1 anhand einer schematischen Aufsicht in Figur 2A und einer schematischen Schnittansicht in Figur 2B. Im Wesentlichen entspricht die Laseranordnung 1 der in den Figuren 1A und 1B gezeigten Laseranordnung.

Im Unterschied hierzu sind Elemente der Laseranordnung derart aufeinander abgestimmt, dass die Betriebstemperaturverteilung in den aktiven Bereiche in lateraler Richtung homogenisiert ist. Bevorzugt weisen die aktiven Bereiche in lateraler Richtung an entsprechenden Orten im jeweiligen aktiven Bereich gleiche Betriebstemperaturen Tₐ, T_{b}, T_{c}, T_{d}, ..., Tₙ auf. Im Unterschied zur Laseranordnung gemäß den Figuren 1A und 1B schließt in der Abwandlung gemäß Figur 2 das Substrat 3 in lateraler Richtung bündig mit dem Träger 6 ab. Die Randfläche 7 des Trägers und die Seitenfläche 9 des Substrats bzw. die Randfläche 8 und die Seitenfläche 10 schließen hierzu bündig miteinander ab und bilden bevorzugt jeweils eine durchgehende, besonders bevorzugt eine ebene Fläche aus. Sowohl das Substrat 3 als auch der Träger 6 begrenzt die Laseranordnung 1 in lateraler Richtung. Weiterhin grenzen die aktiven Bereiche 4a und 4n bzw. die Halbleiterkörper 5a und 5n an die Seitenfläche 10 bzw. 9 an. Die seitens der Seitenflächen 9 und 10 angeordneten Halbleiterkörper 5n bzw. 5a können insbesondere bündig mit dem Substrat 3 abschließen.

Eine laterale Wärmestromaufweitung im Bereich der Seitenflächen 9, 10 und der Randflächen 7, 8 kann so vermieden werden. Die Betriebstemperaturstabilisierung in lateraler Richtung wird in der Folge vereinfacht, da die Betriebstemperatur der randseitig angeordneten aktiven Bereiche aufgrund der Unterdrückung der Wärmestromaufweitung an die der weiter von den Seitenflächen entfernten aktiven Bereiche angeglichen ist. Dies wird durch die Wärmestromlinien 14 und 15 verdeutlicht, die im Unterschied zu den Linien in Figur 1 im Wesentlichen gerade Linien sind und in vertikaler Richtung vom aktiven Bereich in den Träger verlaufen.

Gegebenenfalls können die aktiven Bereiche 4a und 4n, die den Seitenflächen 10 bzw. 9 am nächsten liegen, auch in lateraler Richtung von diesen Seitenflächen beabstandet sein. Um einer maßgeblichen Wärmestromaufweitung im Substrat 3 vorzubeugen, ist dieser Abstand bevorzugt kleiner als derjenige zwischen zwei benachbarten aktiven Bereichen des Laserdiodenchips. Weiterhin ist der Abstand zur Seitenfläche in lateraler Richtung bevorzugt kleiner als der Abstand des der jeweiligen Seitenfläche nächstliegenden aktiven Bereichs zu dem diesem benachbarten aktiven Bereich (etwa kleiner als der Abstand der Bereiche 4a und 4b). Besonders bevorzugt ist der Abstand des der jeweiligen Seitenfläche nächstliegenden aktiven Bereichs zu dieser Seitenfläche kleiner als der kleinste der Abstände zwischen den aktiven Bereichen des Laserdiodenchips. Zur Stabilisierung der Betriebstemperatur können alternativ oder ergänzend die Abstände oder die Querabmessungen der aktiven Bereiche variiert werden (vgl. die Beschreibung der folgenden Ausführungsbeispiele bzw. Abwandlungen).

Weiterhin können die Seitenflächen 9 und 10 von den Randflächen 7 bzw. 8 in lateraler Richtung beabstandet sein. Um einer maßgeblichen Wärmestromaufweitung im Träger 6 vorzubeugen, ist dieser Abstand bevorzugt kleiner als einer der Abstände zwischen zwei benachbarten aktiven Bereichen des Laserdiodenchips und/oder kleiner als der Abstand des der jeweiligen Seitenfläche nächstliegenden aktiven Bereichs von dieser Seitenfläche.

Bei in einem Abstand von 110 µm äquidistant angeordneten aktiven Bereichen gleicher Querabmessung konnte über derartige Abstimmung des Laserdiodenchips und des Trägers die Betriebstemperatur an entsprechenden Orten in verschiedenen aktiven Bereichen im Wesentlichen konstant gehalten werden, während bei einer Laseranordnung mit einem Referenz-Laserdiodenchip ähnlich dem in Figur 1 gezeigten die Betriebstemperatur um ungefähr 38 K schwankte. Bei einem Abstand der Halbleiterkörper von 200 µm betrug die Schwankung der Betriebstemperatur im Referenz-Laserdiodenchip ungefähr 33 K. Auch diese Schwankung konnte kompensiert werden.

Eine entsprechende Kompensation der Schwankung in der Betriebstemperatur aufgrund der Anpassung des Laserdiodenchips 2 an die Abmessung des Trägers konnte auch bei einer Laseranordnung gemäß den Figuren 1C und 1D bzw. 1E erzielt werden. Die randseitigen Kontakte 50a und 50n sind dabei bevorzugt entsprechend den Halbleiterkörpern 5a und 5n in lateraler Richtung möglichst nahe an den Seitenflächen 9, 10 des Substrats 3, und insbesondere am Rand der Halbleiterschichtstruktur 500 angeordnet. In der Folge sind die randseitigen aktiven Bereiche mit Vorteil möglichst nahe am Trägerrand bzw. der Substratkante ausgebildet. Einer Wärmestromaufweitung kann so besonders effizient vorgebeugt werden.

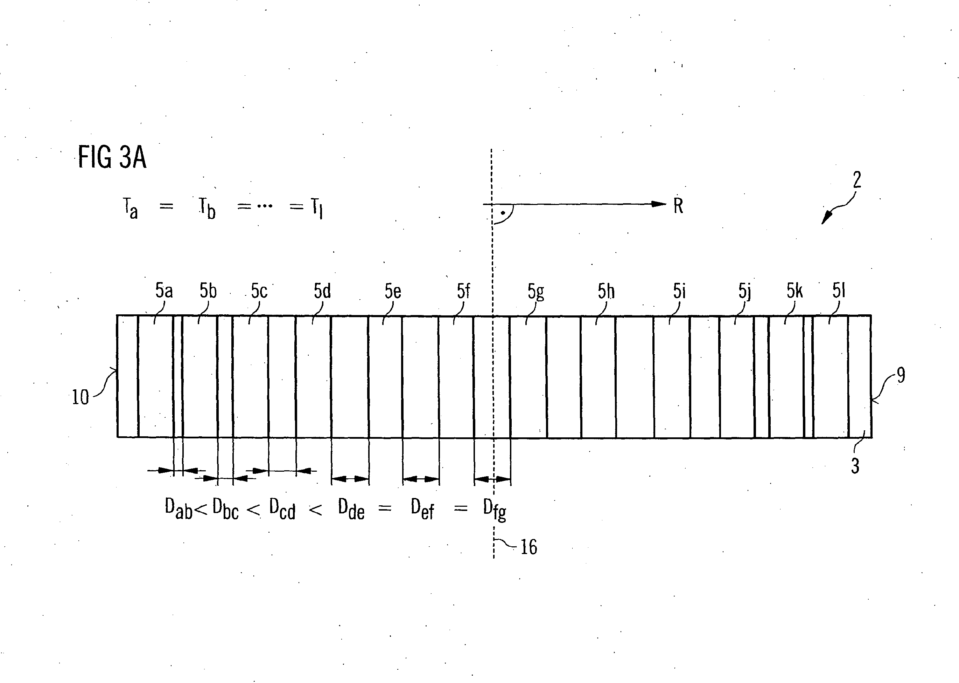

Figur 3A zeigt eine Abwandlungeines Laserdiodenchips 2 anhand einer schematischen Aufsicht.

Der Laserdiodenchip 2 entspricht im Wesentlichen dem im Zusammenhang mit den Figuren 1A und 1B beschriebenen Laserdiodenchip. Im Unterschied hierzu sind die Halbleiterkörper 5a ... 51 mit den aktiven Bereichen nicht äquidistant entlang der lateralen Haupterstreckungsrichtung R angeordnet. Die Abstände D_{ab}, D_{bc}, D_{cd}, D_{de}, D_{ef} bzw. D_{fg} zwischen zwei benachbarten Halbleiterkörpern nehmen vielmehr mit wachsendem Abstand der Halbleiterkörper von der jeweiligen Seitenfläche 10 bzw. 9 des Substrats 3 zu (D_{ab} < D_{bc} < D_{cd}). Die lineare Belegungsdichte des Laserdiodenchips 2 mit aktiven Bereichen nimmt demgemäß in lateraler Richtung mit wachsendem Abstand von der jeweiligen Seitenfläche ab. Unter linearer Belegungsdichte wird hierbei das Verhältnis der beim Überstreichen des Laserdiodenchips entlang der lateralen Haupterstreckungsrichtung R des Laserdiodenchips mit aktiven Bereichen belegten Strecken zu der insgesamt entlang der lateralen Haupterstreckungsrichtung des Laserdiodenchips überstrichenen Strecke verstanden.

Daher wird im Bereich der Seitenflächen 9 und 10 verglichen mit dem Laserdiodenchip aus Figur 1 eine erhöhte Verlustwärmemenge erzeugt. Hierdurch kann die laterale Wärmestromaufweitung, die aufgrund der beabstandeten Anordnung der aktiven Bereiche zur Seitenfläche entsteht, kompensiert werden, und die laterale Betriebstemperaturverteilung der aktiven Bereiche homogenisiert werden. Bevorzugt sind die aktiven Bereiche bzw. die Halbleiterkörper derart angeordnet, dass die Betriebstemperaturen gleich sind (Tₐ = T_{b} = ... = T₁).

Eine Anordnung der aktiven Bereiche bzw. der Halbleiterkörper auf dem Substrat 3 achsensymmetrisch zur Symmetrieachse 16 des Laserdiodenchips 2, die senkrecht zur lateralen Haupterstreckungsrichtung R und/oder parallel zu derjenigen Oberfläche des Substrats 3, auf der die Halbleiterkörper angeordnet sind, verläuft, ist für eine homogene Betriebstemperaturverteilung in lateraler Richtung von besonderem Vorteil. Bevorzugt sind die Halbleiterkörper bzw. die aktiven Bereiche daher symmetrisch zu dieser Symmetrieachse 16 angeordnet. Besonders bevorzugt ist der gesamte Laserdiodenchip 2 achsensymmetrisch zu dieser Achse ausgebildet.

Insgesamt kann so mittels geeigneter Wahl der Abstände zwischen den benachbarten aktiven Bereichen bzw. Halbleiterkörpern, insbesondere auch bei Halbleiterkörpern gleicher Breite, ein lateral in den aktiven Bereichen gleichartig verlaufendes Betriebstemperaturprofil verwirklicht werden.

Als besonders zweckmäßig hat es sich herausgestellt, den Abstand benachbarter aktiver Bereiche, insbesondere in Schritten einer vorgegebenen Größe, zwischen einem kleinsten der Abstände benachbarter aktiver Bereiche von D/3, bevorzugt von D/5, besonders bevorzugt D/10, und einem größten der Abstände benachbarter aktiver Bereiche D zu variieren.

Im zentralen Bereich um die Mitte des Laserdiodenchips 2 sind Schwankungen in der Betriebstemperaturverteilung zwischen verschiedenen aktiven Bereichen, insbesondere in lateraler Richtung, eher gering, sodass auf eine Variation des Abstands zur Homogenisierung des Betriebstemperaturverteilung in diesem Bereich bedingt verzichtet werden kann (D_{de} = D_{ef} = D_{fg} oder vorzugsweise D_{de} < D_{ef} < D_{fg}).

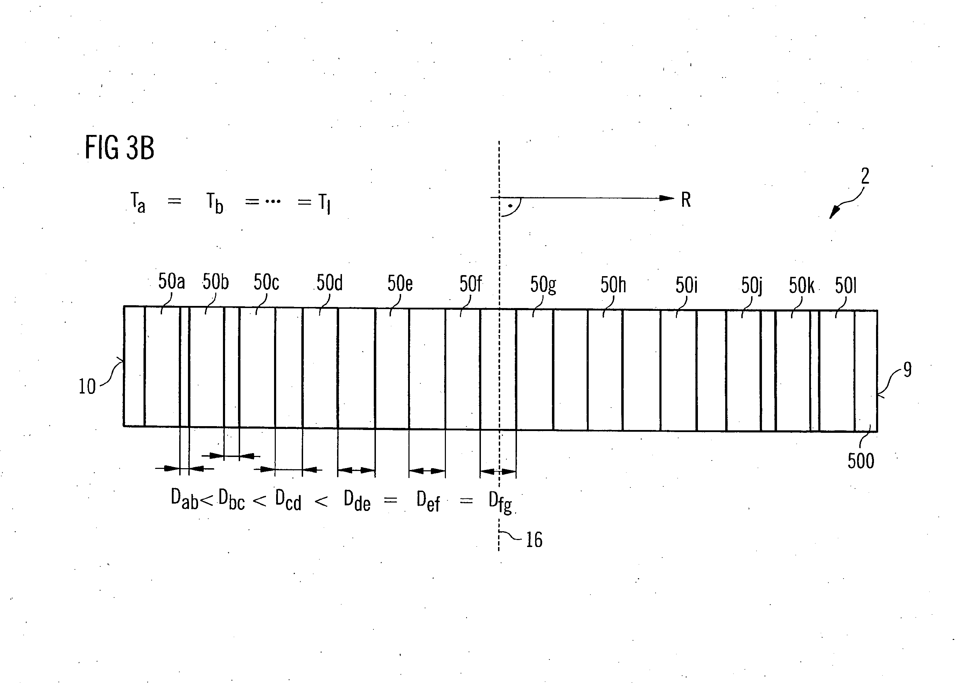

Eine entsprechende Homogenisierung der Betriebstemperatur der aktiven Bereiche kann auch bei einem Laserdiodenchip 2, dessen aktive Bereiche durch diskret voneinander bestromte Gebiete einer durchgehenden aktiven Schicht 400 gebildet sind (vergleiche die Figuren 1C und 1D, bzw. 1E) erreicht werden. Hierzu werden anstatt Abstände zwischen Halbleiterkörpern zu variieren die Abstände zwischen den 50a ... 501 entsprechend variiert werden. Die diesbezüglichen obigen Ausführungen treffen dementsprechend auch auf die in Figur 3B in schematischer Aufsicht dargestellte Abwandlung eines Laserdiodenchips 2 zu. Die Ausführungen für die Halbleiterkörper bzw. die aktiven Bereiche sind also insbesondere auch für die Ausbildung der Kontakte zutreffend.

Die Kontakte sind vorzugsweise in Aufsicht streifenartig, insbesondere rechtecksartig ausgebildet. Insbesondere können die Kontakte gleiche Breiten aufweisen.

Mittels einer derartigen Variation des Abstands der benachbarten aktiven Bereiche kann ein Betriebstemperaturgradient über verschiedene aktive Bereiche eines Referenz-Laserdiodenchips nicht nur kompensiert, sondern sogar umgekehrt werden.

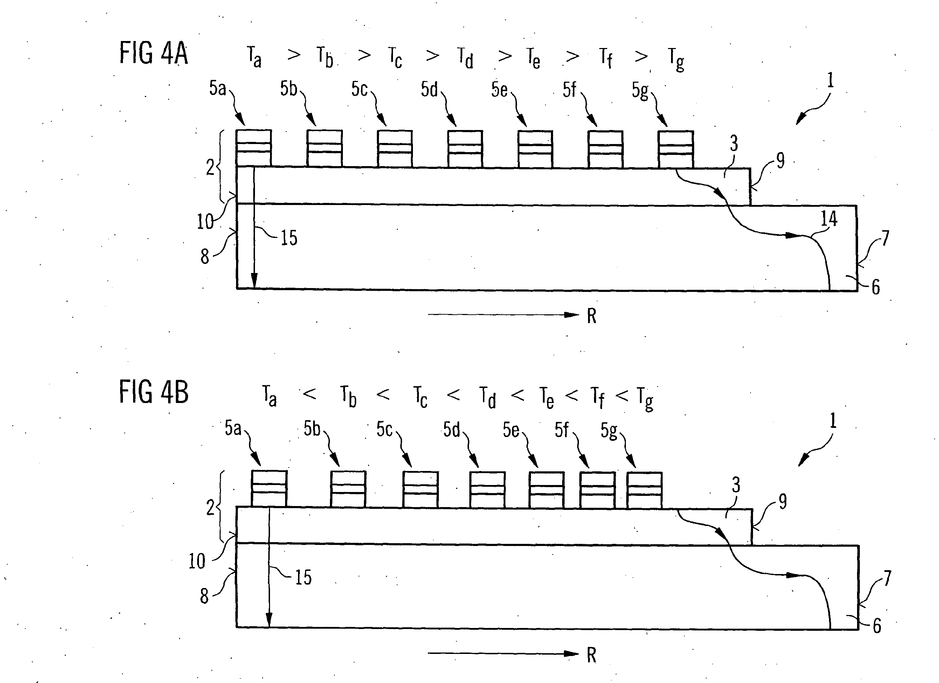

Dies ist anhand der Figuren 4A und 4B verdeutlicht, die jeweils eine schematische Schnittansicht durch eine Laseranordnung 1 ähnlich den in den Figuren 1A, 1B und 2 gezeigten Laseranordnungen zeigen. Die Halbleiterkörper 5a ... 5g bzw. die aktiven Bereiche der Laserdiodenchips weisen jeweils gleiche Breiten auf.

Aufgrund der Wärmestromaufweitung der beim Referenz-Laserdiodenchips gemäß Figur 4A äquidistant angeordneten Halbleiterkörper 5a ... 5g seitens der Seitenfläche 9 nimmt die Betriebstemperatur der aktiven Bereiche ausgehend von dieser Seitenfläche in lateraler Richtung zu. Beim Laserdiodenchip gemäß Figur 4B ist der Abstand benachbarter aktiver Bereiche seitens der Seitenfläche 9 gegenüber dem Referenz-Laserdiodenchip verringert und seitens der Seitenfläche 10 vergrößert. Durch derartige Erhöhung der linearen Belegungsdichte des Laserdiodenchips 2 mit aktiven Bereichen gegenüber derjenigen des Referenz-Laserdiodenchips aus Figur 4A seitens der Seitenfläche 9 des Substrats 3 kann, trotz der lateralen Wärmestromaufweitung seitens der Seitenfläche 9, der Betriebstemperaturgradient gegenüber dem des Referenz-Laserdiodenchips umgekehrt werden. Die lineare Belegungsdichte nimmt in Figur 4B in lateraler Richtung R ausgehend von dem der Seitenfläche 9 nächstliegenden aktiven Bereich mit wachsendem Abstand von der Seitenfläche 9 ab.

Entsprechendes gilt für die Beeinflussung der Betriebstemperaturen für eine Laseranordnung 1 gemäß den Figuren 1C, 1D, 1E bzw. den Chip gemäß Figur 3B für die Variation der Abstände der Kontakte.

Bei den im Zusammenhang mit den Figuren 1, 2 und 3 beschriebenen Laserdiodenchips 2 weisen die aktiven Bereiche vorzugsweise jeweils die gleiche aktive Fläche auf.

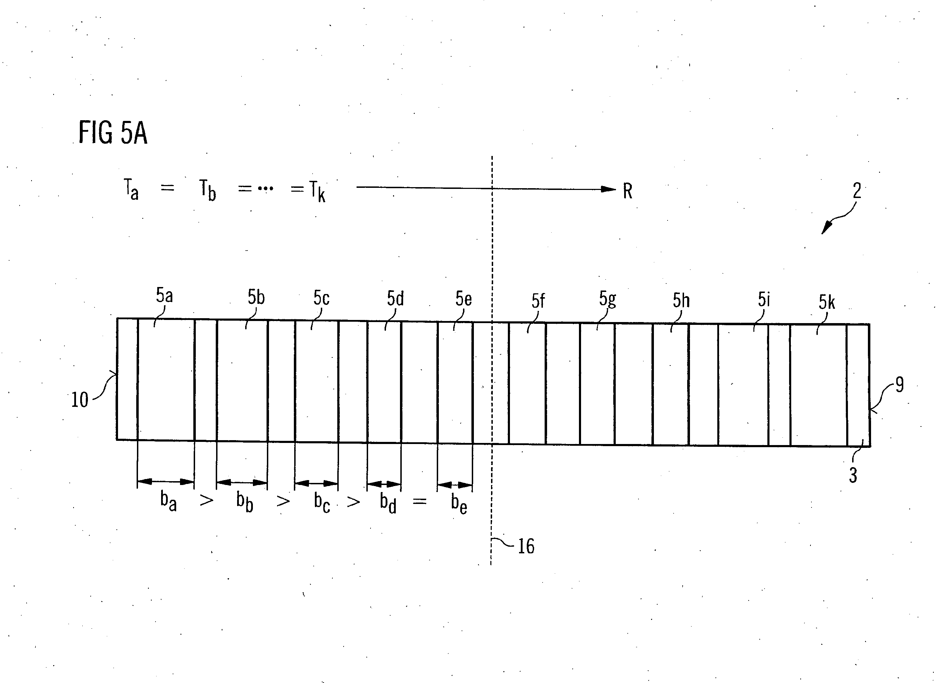

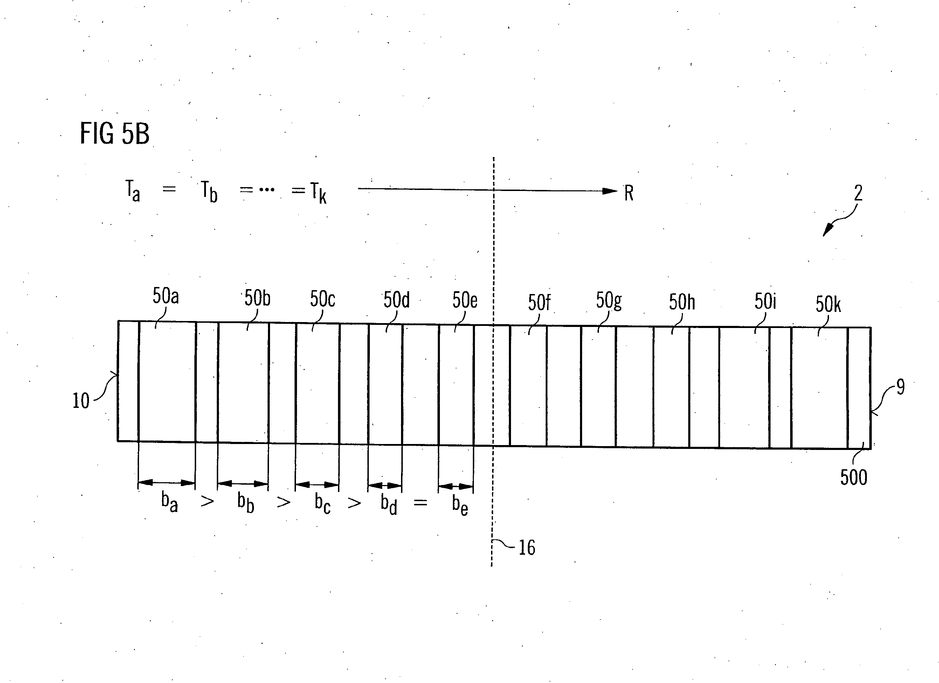

Figur 5 zeigt ein Ausführungsbeispiel eines erfindungsgemäßen Laserdiodenchips 2 anhand einer schematischen Aufsicht. Im Wesentlichen entspricht der Laserdiodenchip 2 dem im Zusammenhang mit Figur 3 beschriebenen Laserdiodenchip, wobei anstatt oder zusätzlich zur Variation der Abstände zwischen den Halbleiterkörper 5a ... 5k bzw. zwischen den aktiven Bereichen, deren Querabmessungen, d. h. die Breiten bₐ ... bₖ der Halbleiterkörper bzw. der aktiven Bereiche, variieren. Die aktiven Bereiche weisen dementsprechend verschiedene Breiten auf, können aber gegebenenfalls äquidistant angeordnet sein. Auch durch Variation der Breiten kann die lineare Belegungsdichte des Laserdiodenchips mit aktiven Bereichen in Gebieten des Laserdiodenchips mit erhöhter lateraler Wärmestromaufweitung derart erhöht werden, dass die Betriebstemperaturen der aktiven Bereiche im Wesentlichen konstant sind (Tₐ = ... = Tₖ).

Die Breiten der aktiven Bereiche nehmen bevorzugt mit wachsendem Abstand von der Seitenfläche 10 des Substrats 3 ab (bₐ > b_{b} > b_{c} > b_{d}). Auch hierbei können entsprechend der Abwandlung gemäß Figur 3 vergleichsweise mittig auf dem Substrat 3 angeordnete aktive Bereiche aufgrund des vergleichsweise geringen Einflusses der Wärmestromaufweitung auf die Betriebstemperatur in diesem Gebiet mit gleichen Breiten ausgebildet sein (b_{d} = bₑ). Eine achsensymmetrische Anordnung zur Symmetrieachse 16 ist für ein homogenes, insbesondere symmetrisches, Betriebstemperaturprofil wiederum besonders geeignet.

Als besonders zweckmäßig hat es sich erwiesen, dass die größte der Breiten der aktiven Bereiche des Laserdiodenchips das 1,2-fache oder mehr, bevorzugt das 1,5-fache oder mehr, besonders bevorzugt das 2-fache oder mehr, der kleinsten der Breiten der aktiven Bereiche des Laserdiodenchips in der lateralen Haupterstreckungsrichtung beträgt.

Der anhand von Figur 5B in schematischer Aufsicht dargestellte Laserdiodenchip 2 entspricht bis auf die Ausbildung der Kontakte dem in Zusammenhang mit den Figuren 1C und 1D bzw. 1E beschriebenen Laserdiodenchips. Auch bei diesem Chip ist die Betriebstemperaturverteilung stabilisiert, wobei im Gegensatz den Halbleiterkörpern wie in Figur 5A die Breite der Kontakte 50a ... 50k entsprechend variiert wurde. Die Ausführungen zu den Halbleiterkörpern können also für die Kontaktstreifen, insbesondere deren Breite, ebenfalls zutreffen.

Die aktiven Bereiche weisen gemäß Figur 5 verschiedene aktive Flächen auf.

Die Abwandlungen gemäß den Figuren 3A, 3B und 4B und das Ausführungsbeispiel der Figur 5, in denen die Betriebstemperaturverteilung durch die Ausbildung bzw. Anordnung der aktiven Bereiche beeinflusst wird, können gegenüber der Abwandlung gemäß Figur 2, aufgrund des verringerten Justage - bzw. Abstimmungsaufwandes des Laserdiodenchips zum Träger, vereinfacht verwirklicht werden. Bei den erstgenannten Ausführungsbeispielen bzw. Abwandlungen kann es jedoch erforderlich sein, das Herstellungsverfahren des Laserdiodenchips anzupassen und von einem standardisierten Prozess abzuweichen. Beispielsweise kann es erforderlich sein, Masken, die bei der Ausbildung der Halbleiterkörper bzw. der Kontakte Anwendung finden, an die geänderten Abmessungen und/oder Abstände der Halbleiterkörper bzw. der Kontakte anzupassen. Hierauf kann bei einer Abstimmung des Laserdiodenchips auf den Träger, wie z.B. bei der Abwandlung gemäß Figur 2 verzichtet werden. Gegebenenfalls kann im Rahmen der Erfindung durch geeignete gezielte Anordnung und/oder Ausbildung der aktiven Bereiche auch ein vorgegebenes Betriebstemperaturprofil über die aktiven Bereiche geformt werden, das inhomogen verläuft, d.h. die Betriebstemperaturen in verschiedenen aktiven Bereichen, insbesondere in lateraler Richtung, können gezielt voneinander verschieden ausgebildet sein.

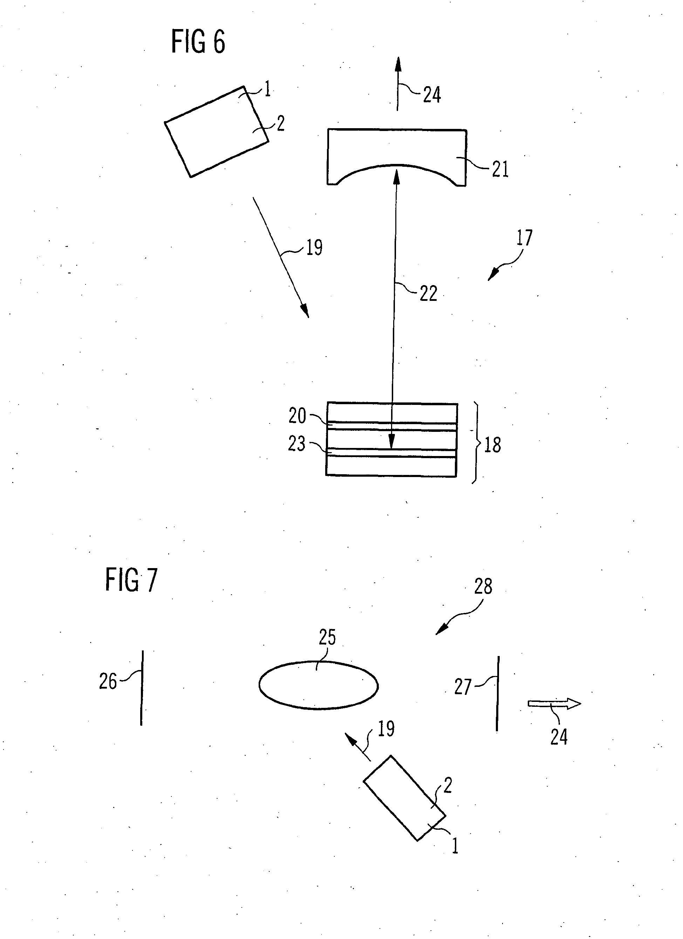

Figur 6 zeigt eine schematische Ansicht eines Ausführungsbeispiels eines erfindungsgemäßen optisch gepumpten Halbleiterlasers.

Der optisch gepumpte Halbleiterlaser 17 umfasst eine oberflächenemittierende Halbleiterstruktur 18, die mittels eines Laserdiodenchips 2 oder einer Laseranordnung 1 als Pumpstrahlungsquelle, die gemäß einem der vorhergehenden Ausführungsbeispiele bzw. Abwandlungen ausgeführt sein können, optisch gepumpt ist. Hierzu ist die Pumpstrahlungsquelle derart angeordnet, dass Pumpstrahlung 19 in einer aktiven Zone 20 des Halbleiterlasers, beispielsweise eine Quantentopfstruktur umfassend, absorbiert wird. Die aktive Zone wird hierdurch optisch zur Emission von einer gegenüber der Pumpstrahlung längerwelligen Strahlung angeregt, die aus einer Oberfläche der Halbleiterstruktur austritt. In einem externen Resonator des Halbleiterlasers 17, der mittels zumindest eines externen Spiegels 21 begrenzt wird, kann sich so ein Strahlungsfeld 22 aufbauen, das in der Halbleiterstruktur 18 verstärkt werden kann. Der Resonator wird durch einen weiteren Spiegel 23 begrenzt, der bevorzugt, z.B. als Braggspiegel, in der Halbleiterstruktur 18, insbesondere zusammen mit der aktiven Zone 20, monolithisch integriert ist. Der externe Spiegel 21 ist bevorzugt als Auskoppelspiegel von Laserstrahlung 24 aus dem Resonator ausgebildet. Der Halbleiterlaser ist insbesondere als optisch gepumpter VECSEL ausgeführt.

Da das Emissionsspektrum der Pumpstrahlungsquelle den obigen Ausführungen entsprechend über die Stabilisierung der Betriebstemperatur über die Ausbildung und/oder die Anordnung der aktiven Bereiche vereinfacht vergleichsweise schmalbandig sein kann, kann der Halbleiterlaser 17 mittels einer betriebstemperaturstabilisierten Pumpstrahlungsquelle sehr effizient gepumpt werden.

Figur 7 zeigt eine schematische Ansicht eines Ausführungsbeispiels eines optisch gepumpten Lasers. Wie im Zusammenhang mit Figur 6 beschrieben wird ein Laserdiodenchip 2 oder eine Laseranordnung 1, insbesondere in hinsichtlich der Betriebstemperatur stabilisierter Ausführung, als Pumpstrahlungsquelle eingesetzt. In einem für das Erreichen von Laseraktivität geeigneten Verstärkungsmedium 25 wird die Pumpstrahlung 19 absorbiert und reemittiert. Die reemittierte Strahlung wird in einem mittels der Spiegel 26 und 27 gebildeten Resonator und mittels des Verstärkungsmediums 25 verstärkt. Die verstärkte Strahlung kann als Laserstrahlung 24 aus dem Resonator auskoppeln. Der in Figur 7 gezeigte Laser 28 ist beispielsweise als Festkörperscheibenlaser, Festkörperstablaser oder als Faserlaser ausgeführt. Aufgrund des in der Regel schmalen Absorptionsspektrums im Verstärkungsmedium 25 ist ein Pumpen mit einer Pumpstrahlungsquelle, welche, wie die betriebstemperaturstabilisierte Laseranordnung oder ein entsprechend stabilisierter Laserdiodenchip, ein schmales Emissionsspektrum aufweist, von besonderem Vorteil.

Ferner kann auch bei einer Laserdiodenvorrichtung mit diskreten, auf einem gemeinsamen Chipträger angeordneten Laserdiodenchips durch Anpassung der Abmessung der Laserdiodenvorrichtung mit den diskreten Chips an einen wärmeleitenden (Chip)Träger, der Variation der Querabmessungen und/oder einer Variation der Abstände der Laserdiodenchips eine entsprechende Betriebstemperaturstabilisierung erreicht werden. Bei Laserdiodenchips, welche eine Mehrzahl von aktiven Bereichen umfassen, ist eine Betriebstemperaturstabilisierung jedoch aufgrund der besonders kompakten Ausbildung von besonderem Vorteil.

Weiterhin kann eine Laseranordnung im Rahmen der Erfindung auch eine Mehrzahl von vorzugsweise betriebstemperaturstabilisierten Laserdiodenchips umfassen.

Es sei angemerkt, dass Abwandlungen der Erfindung gegebenenfalls auch bei anderen strahlungsemittierenden Halbleiterchips, etwa LED-Chips mit einer Mehrzahl von, insbesondere auf einem gemeinsamen Substrat angeordneten, aktiven Bereichen, Anwendung finden kann. Wegen der oftmals besonders hohen Verlustleistung bei Halbleiterlasern ist die Erfindung für Laser jedoch besonders geeignet.

## Patentansprüche

1. Laserdiodenvorrichtung (2) mit einer Mehrzahl von lateral nebeneinander angeordneten, zur Strahlungserzeugung geeigneten aktiven Bereichen (4a ... 4n), wobei
- die aktiven Bereiche (4a ... 4n) in voneinander durch einen Freiraum beabstandeten Halbleiterkörpern (5a ... 5n) ausgebildet sind, wobei jeder Halbleiterkörper (5a... 5n) eine kantenemittierende Laserstruktur ist,
- die aktiven Bereiche (4a ... 4n) auf einem gemeinsamen Substrat (3) angeordnet sind, das aus dem Aufwachssubstrat für die aktiven Bereiche gebildet ist,
- alle aktiven Bereiche (4a ... 4n) im Betrieb Laserstrahlung emittieren,
- die Laserdiodenvorrichtung mindestens zwei die Laserdiodenvorrichtung lateral begrenzende Seitenfläche (9, 10) aufweist,
- die aktiven Bereiche (4a ... 4n) achsensymmetrisch zu einer Symmetrieachse (16) der Laserdiodenvorrichtung (2) angeordnet sind, wobei die Symmetrieachse (16) senkrecht zur einer lateralen Haupterstreckungsrichtung der Laserdiodenvorrichtung und parallel zu derjenigen Oberfläche des Substrats (3), auf der die aktiven Bereiche (4a ... 4n) angeordnet sind, verläuft, eine Querabmessung (ba... bn) der aktiven Bereiche in lateraler Richtung variiert und die Querabmessung der aktiven Bereiche mit wachsendem Abstand von der nächstliegenden Seitenfläche in Richtung der Symmetrieachse (16) abnimmt, so dass die Querabmessung (ba ... bn) eines aktiven Bereichs (4a ... 4n) im Bereich der nächstliegenden Seitenfläche größer ist als die Querabmessung eines weiteren aktiven Bereichs, der dem ersteren aktiven Bereich benachbart ist und weiter von der nächstliegenden Seitenfläche (9, 10) beabstandet ist als der erstere aktive Bereich, und
- die Laserdiodenvorrichtung im Betrieb eine Betriebstemperaturverteilung über verschiedene aktive Bereiche (4a...4n) entlang der Haupterstreckungsrichtung der Laserdiodenvorrichtung aufweist, die verglichen mit einer weiteren Laserdiodenvorrichtung mit äquidistant angeordneten aktiven Bereichen jeweils gleicher Querabmessung homogener ist.

2. Laserdiodenvorrichtung nach Anspruch 1, **dadurch gekennzeichnet, dass** der Abstand (Da... Dc) zwischen den aktiven Bereichen eines Paars mit zwei benachbarten aktiven Bereichen kleiner ist als der Abstand zwischen den aktiven Bereichen eines weiteren Paars mit zwei benachbarten aktiven Bereichen, das einen größeren Abstand zur nächstliegenden Seitenfläche (9, 10) aufweist als das erstere Paar.

3. Laserdiodenvorrichtung nach mindestens einem der Ansprüche 1 bis 2, **dadurch gekennzeichnet, dass** der jeweilige Abstand (Da... Dc) zwischen benachbarten aktiven Bereichen mit wachsendem Abstand der aktiven Bereiche von der nächstliegenden Seitenfläche (9, 10) zunimmt.

4. Laserdiodenvorrichtung nach mindestens einem der vorherigen Ansprüche, **dadurch gekennzeichnet, dass** zwei aktive Bereiche einem gemeinsamen Laserdiodenbarren angehören.

5. Laserdiodenvorrichtung nach mindestens einem der Ansprüche 1 bis 4, **dadurch gekennzeichnet, dass** eine der S eitenflächen (9, 10) zumindest bereichsweise durch das Substrat (3) gebildet ist.

6. Laserdiodenvorrichtung nach mindestens einem der vorhergehenden Ansprüche, **dadurch gekennzeichnet, dass** der einer der S eitenflächen (9, 10) nächstliegende aktive Bereich von der Seitenfläche einen Abstand aufweist, der kleiner oder gleich einem der Abstände zwischen zwei benachbarten aktiven Bereichen ist.

7. Laserdiodenvorrichtung nach mindestens einem der vorhergehenden Ansprüche, **dadurch gekennzeichnet, dass** der Abstand des einer der S eitenflächen (9, 10) nächstliegenden aktiven Bereichs von der Seitenfläche kleiner ist als der Abstand zwischen diesem aktiven Bereich und dem diesem aktiven Bereich benachbarten aktiven Bereich.

8. Laserdiodenvorrichtung nach mindestens einem der vorhergehenden Ansprüche, **dadurch gekennzeichnet, dass** ein aktiver Bereich an eine der Seitenfläche angrenzt.

9. Laseranordnung mit mindestens einer Laserdiodenvorrichtung (2) nach einem der vorhergehenden Ansprüche wobei
- die Laserdiodenvorrichtung auf einem Träger (6) angeordnet ist sowie
- der Abstand zwischen einer der S eitenflächen und einem den Träger seitens der Seitenfläche lateral begrenzenden Rand (7, 8) geringer ist als der Abstand zwischen dem der Seitenfläche nächstliegenden aktiven Bereich und der Seitenfläche und/oder
- der Abstand zwischen der Seitenfläche und dem Rand geringer ist als einer der Abstände zwischen zwei benachbarten aktiven Bereichen der Laserdiodenvorrichtung.

10. Laseranordnung nach Anspruch 9, **dadurch gekennzeichnet, dass** der Abstand der Seitenfläche (9, 10) vom Rand (7, 8) geringer ist als der kleinste der Abstände zwischen den aktiven Bereichen der Laserdiodenvorrichtung (2).

11. Laseranordnung nach Anspruch 9 oder 10, **dadurch gekennzeichnet, dass** die Seitenfläche (9, 10) bündig mit dem Rand (7, 8) abschließt.

12. Laseranordnung nach mindestens einem der Ansprüche 9 bis 11, **dadurch gekennzeichnet, dass** der Träger (6) als Wärmesenke oder als Submount ausgeführt ist.

13. Optisch gepumpter Laser (17), der mittels einer Laserdiodenvorrichtung (2) gemäß einem der Ansprüche 1 bis 8 oder einer Laseranordnung (1) gemäß einem der Ansprüche 9 bis 12 gepumpt ist.

14. Laser nach Anspruch 13, **dadurch gekennzeichnet, dass** der Laser als Festkörperlaser, insbesondere als Festkörperscheibenlaser oder Festkörperstablaser, als Faserlaser oder als Halbleiterlaser, insbesondere als Halbleiterscheibenlaser, ausgeführt ist.

15. Laser nach Anspruch 14, **dadurch gekennzeichnet, dass** der Laser ein Halbleiterlaser (17) ist, der zum Betrieb mit einem externen Resonator vorgesehen ist.

## Claims

1. Laser diode apparatus (2) having a plurality of active regions (4a ... 4n) which are arranged laterally alongside one another and are suitable for radiation production, wherein
- the active regions (4a ... 4n) are formed in semiconductor bodies (5a ... 5n) separated from one another by a free space, wherein each semiconductor body (5a ... 5n) is an edge-emitting laser structure,
- the active regions (4a ... 4n) are arranged on a common substrate (3), which is formed from the growth substrate for the active regions,
- all the active regions (4a ... 4n) emit laser radiation during operation,
- the laser diode apparatus has at least two side surfaces (9, 10) which laterally bound the laser diode apparatus,
- the active regions (4a ... 4n) are arranged axially symmetrically with respect to an axis (16) of symmetry of the laser diode apparatus (2), wherein the axis (16) of symmetry runs perpendicular to a lateral main extent direction of the laser diode apparatus and parallel to that surface of the substrate (3) on which the active regions (4a ... 4n) are arranged, a lateral size (ba ... bn) of the active regions varies in the lateral direction, and the lateral size of the active regions decreases with increasing distance from the closest side surface in the direction of the axis (16) of symmetry, such that the lateral size (ba ... bn) of one active region (4a ... 4n) in the region of the closest side surface is greater than the lateral size of a further active region which is adjacent to the first active region and is further away from the closest side surface (9, 10) than the first active region, and
- the laser diode apparatus has during operation an operating temperature distribution over different active regions (4a ... 4n) along the main extent direction of the laser diode apparatus which is more homogeneous than in the case of a further laser diode apparatus having active regions arranged at equal intervals, and each of the same lateral size.

2. The laser diode apparatus according to Claim 1,
**characterized in that**
the distance (Dₐ ... D_{c}) between the active regions of one pair with two adjacent active regions is shorter than the distance between the active regions of a further pair with two adjacent active regions which is further away from the closest side surface (9, 10) than the first pair.

3. Laser diode apparatus according to at least one of Claims 1 and 2,
**characterized in that**
the respective distance (Dₐ ... D_{c}) between adjacent active regions increases as the distance of the active regions from the closest side surface (9, 10) increases.

4. Laser diode apparatus according to at least one of the preceding claims,
**characterized in that**
two active regions are associated with one common laser diode bar.

5. Laser diode apparatus according to at least one of Claims 1 to 4,
**characterized in that**
one of the side surfaces (9, 10) is formed by the substrate (3), at least in places.

6. Laser diode apparatus according to at least one of the preceding claims,
**characterized in that**
that active region which is closest to one of the side surfaces (9, 10) is at a distance from the side surface which is shorter than or equal to one of the distances between two adjacent active regions.

7. Laser diode apparatus according to at least one of the preceding claims,
**characterized in that**
the distance between that active region which is closest to one of the side surfaces (9, 10) and the side surface is shorter than the distance between this active region and the active region which is adjacent to this active region.

8. Laser diode apparatus according to at least one of the preceding claims,
**characterized in that**
one active region is adjacent to one of the side surfaces.

9. Laser arrangement having at least one laser diode apparatus (2) according to one of the preceding claims, with
- the laser diode apparatus being arranged on a mount (6), and
- the distance between one of the side surfaces and an edge (7, 8) which laterally bounds the mount to the side of the side surface being shorter than the distance between the active region closest to the side surface and the side surface, and/or
- the distance between the side surface and the edge being shorter than one of the distances between two adjacent active regions of the laser diode apparatus.

10. Laser arrangement according to Claim 9,
**characterized in that**
the distance between the side surface (9, 10) and the edge (7, 8) is shorter than the shortest of the distances between the active regions of the laser diode apparatus (2).

11. Laser arrangement according to Claim 9 or 10,
**characterized in that**
the side surface (9, 10) ends flush with the edge (7, 8).

12. Laser arrangement according to at least one of Claims 9 to 11,
**characterized in that**
the mount (6) is in the form of a heat sink or a submount.

13. Optically pumped laser (17),
which is pumped by means of a laser diode apparatus (2) as claimed in one of claims 1 to 8, or by means of a laser arrangement (1) according to one of Claims 9 to 12.

14. Laser according to Claim 13,
**characterized in that**
the laser is in the form of a solid-state laser, in particular a solid-state disk laser or a solid-state rod laser, a fiber laser or a semiconductor laser, in particular a semiconductor disk laser.

15. Laser according to Claim 14,
**characterized in that**
the laser is a semiconductor laser (17) which is intended for operation with an external resonator.

## Revendications

1. Dispositif à diode laser (2) comprenant une pluralité de zones actives (4a, ..., 4n) adaptées à la génération d'un rayonnement disposées latéralement côte à côte,
- les zones actives (4a, ..., 4n) étant configurées dans des corps en semiconducteur (5a, ..., 5n) espacés les uns des autres par un espace libre, chaque corps en semiconducteur (5a, ..., 5n) étant une structure laser à émission par les bords,
- les zones actives (4a, ..., 4n) étant disposées sur un substrat (3) commun qui est formé à partir du substrat de croissance pour les zones actives,
- toutes les zones actives (4a, ..., 4n) émettant, en fonctionnement, un rayonnement laser,
- le dispositif à diode laser présentant au moins deux surfaces latérales (9, 10) qui délimitent latéralement le dispositif à diode laser,
- les zones actives (4a, ..., 4n) étant disposées en symétrie par rapport à un axe de symétrie (16) du dispositif à diode laser (2), l'axe de symétrie (16) s'étendant perpendiculairement à un sens de projection principal latéral du dispositif à diode laser et parallèlement à la surface du substrat (3) sur laquelle sont disposées les zones actives (4a, ..., 4n), une dimension transversale (ba, ..., bn) des zones actives dans la direction latérale variant et la dimension transversale des zones actives diminuant dans la direction de l'axe de symétrie (16) à mesure que l'écart par rapport à la surface latérale la plus proche augmente, de sorte que la dimension transversale (ba, ..., bn) d'une zone active (4a, ..., 4n) dans la zone de la surface latérale la plus proche est plus grande que la dimension transversale d'une autre zone active qui est voisine de la première zone active et qui est plus écartée de la surface latérale (9, 10) la plus proche que la première zone active, et
- le dispositif à diode laser présentant, en fonctionnement, une distribution de la température de service sur différentes zones actives (4a, ..., 4n) le long du sens de projection principal du dispositif à diode laser qui est plus homogène en comparaison d'un autre dispositif à diode laser comprenant des zones actives disposées de manière équidistante ayant respectivement la même dimension latérale.

2. Dispositif à diode laser selon la revendication 1, **caractérisé en ce que** l'écart (Da, ..., Dc) entre les zones actives d'une paire comprenant deux zones actives voisines est plus petit que l'écart entre les zones actives d'une autre paire comprenant deux zones actives voisines qui présente un écart par rapport à la surface latérale (9, 10) la plus proche qui est plus grand que celui de la première paire.

3. Dispositif à diode laser selon au moins l'une des revendications 1 à 2, **caractérisé en ce que** l'écart (Da, ..., Dc) respectif entre les zones actives voisines augmente à mesure que l'écart des zones actives par rapport à la surface latérale (9, 10) la plus proche augmente.

4. Dispositif à diode laser selon au moins l'une des revendications précédentes, **caractérisé en ce que** deux zones actives appartiennent à une barre de diodes laser commune.

5. Dispositif à diode laser selon au moins l'une des revendications 1 à 4, **caractérisé en ce que** l'une des surfaces latérales (9, 10) est formée par le substrat (3) au moins dans certaines zones.

6. Dispositif à diode laser selon au moins l'une des revendications précédentes, **caractérisé en ce que** la zone active la plus proche de l'une des surfaces latérales (9, 10) présente par rapport à la surface latérale un écart qui est inférieur ou égal à l'un des écarts entre deux zones actives voisines.

7. Dispositif à diode laser selon au moins l'une des revendications précédentes, **caractérisé en ce que** l'écart de la zone active la plus proche de l'une des surfaces latérales (9, 10) par rapport à la surface latérale est inférieur à l'écart entre cette zone active et la zone active voisine de cette zone active.

8. Dispositif à diode laser selon au moins l'une des revendications précédentes, **caractérisé en ce qu'**une zone active est contiguë à l'une des surfaces latérales.

9. Arrangement laser comprenant au moins un dispositif à diode laser (2) selon l'une des revendications précédentes,
- le dispositif à diode laser étant disposé sur un support (6) et
- l'écart entre l'une des surfaces latérales et un bord (7, 8) qui délimite latéralement le support du côté de la surface latérale étant inférieur à l'écart entre la zone active la plus proche de la surface latérale et la surface latérale et/ou
- l'écart entre la surface latérale et le bord étant inférieur à l'un des écarts entre deux zones actives voisines du dispositif à diode laser.

10. Arrangement laser selon la revendication 9, **caractérisé en ce que** l'écart entre la surface latérale (9, 10) et le bord (7, 8) est inférieur que le plus petit des écarts entre les zones actives du dispositif à diode laser (2).

11. Arrangement laser selon la revendication 9 ou 10, **caractérisé en ce que** la surface latérale (9, 10) se termine justement avec le bord (7, 8).

12. Arrangement laser selon au moins l'une des revendications 9 à 11, **caractérisé en ce que** le support (6) est réalisé sous la forme d'un dissipateur thermique ou d'un sous-support.

13. Laser (17) à pompage optique qui est pompé au moyen d'un dispositif à diode laser (2) selon au moins l'une des revendications 1 à 8 ou d'un arrangement laser (1) selon l'une des revendications 9 à 12.

14. Laser selon la revendication 13, **caractérisé en ce que** le laser est réalisé sous la forme d'un laser à corps solide, notamment sous la forme d'un laser à disque à corps solide ou d'un laser en tige à corps solide, sous la forme d'un laser à fibre ou d'un laser en semiconducteur, notamment sous la forme d'un laser à disque en semiconducteur.

15. Laser selon la revendication 14, **caractérisé en ce que** le laser est un laser en semiconducteur (17) qui est conçu pour fonctionner avec un résonateur externe.
